# EUROPEAN PATENT APPLICATION

(11) **EP 4 439 100 A1**
(43) Date of publication of application: **02.10.2024**
(21) Application number: 23214807.2
(22) Date of filing: 07.12.2023
(51) Int. Cl.: G01R 31/317

(54) **INFIELD TEST AND DEBUG**

(30) Priority: 30.03.2023 US 202318193278
(71) Applicant: INTEL Corporation, Santa Clara, CA 95054 (US)
(72) Inventor: Kandula, Rakesh, Bangalore (IN); Ravipati, VasuBabu, Bangalore (IN); Beaumont, Thierry, Saint Germain en Laye (FR); Pasumarthy, Dhanumjai, 500081 Hyderabad, Telangana (IN); Kamma, Sudhakar, El Dorado Hills CA (US)
(74) Representative: Samson & Partner Patentanwälte mbB

(57) **Abstract**

Techniques for debug of compute logic (e.g., a part of a system on a chip) are described. In some examples, a plurality of infield testing debug and status registers are to store information about the execution of an infield test; and a plurality of infield control debug registers are to control the infield test, wherein access to the plurality of infield testing debug registers and the plurality of infield control debug registers is programmable.

## Description

### BACKGROUND

ISO 26262 defines the standards for infield testing for automotive system-on-a-chips (SoCs), particularly ISO26262 Part 5 that requires addressing a latent fault by implementing a latent fault detection mechanism. Infield testing allows to detect faults in an autonomous driving system (ADS) prior to its usage and while in the field. For example, performing an infield test (IFT) once every 24 hours should guarantee the proper behavior of an SoC.

### BRIEF DESCRIPTION OF DRAWINGS

Various examples in accordance with the present disclosure will be described with reference to the drawings, in which:
FIG. 1 illustrates examples of prior art data flow for infield testing.
FIG. 2 illustrates examples of an architecture for allowing access to a test access port (TAP) network by an external debugger and infield firmware (IFW).
FIG. 3 illustrates examples of using an architecture for allowing access to a TAP network by an external debugger and infield firmware.
FIG. 4 illustrates examples of data flow for infield testing when the infield testing FW control and debug/status registers are duplicated in an infield testing register (FW memory mapped input/output (MMIO)) space and tap accessible register space.
FIG. 5 illustrates examples of selective IFT control registers and IFT debug registers partitioning.
FIG. 6 illustrates examples of an arbitration finite state machine (FSM) used by the FW2TAP.
FIG. 7 illustrates examples of a method of using configurable IFT register allocation.
FIG. 8 illustrates an example computing system.
FIG. 9 illustrates a block diagram of an example processor and/or System on a Chip (SoC) that may have one or more cores and an integrated memory controller.
FIG. 10 is a block diagram illustrating a computing system configured to implement one or more aspects of the examples described herein.
FIG. 11A illustrates examples of a parallel processor.
FIG. 11B illustrates examples of a block diagram of a partition unit.
FIG. 11C illustrates examples of a block diagram of a processing cluster within a parallel processing unit.
FIG. 11D illustrates examples of a graphics multiprocessor in which the graphics multiprocessor couples with the pipeline manager of the processing cluster.
FIGS. 12A-12C illustrate additional graphics multiprocessors, according to examples.
FIG. 13 shows a parallel compute system 1300, according to some examples.
FIGS. 14A-14B illustrate a hybrid logical/physical view of a disaggregated parallel processor, according to examples described herein.
FIG. 15(A) is a block diagram illustrating both an example in-order pipeline and an example register renaming, out-of-order issue/execution pipeline according to examples.
FIG. 15(B) is a block diagram illustrating both an example in-order architecture core and an example register renaming, out-of-order issue/execution architecture core to be included in a processor according to examples.
FIG. 16 illustrates examples of execution unit(s) circuitry, such as execution unit(s) circuitry.
FIG. 17 is a block diagram of a register architecture according to some examples.
FIG. 18 is a block diagram illustrating the use of a software instruction converter to convert binary instructions in a source ISA to binary instructions in a target ISA according to examples.
FIG. 19 is a block diagram illustrating an IP core development system that may be used to manufacture an integrated circuit to perform operations according to some examples.

### DETAILED DESCRIPTION

The present disclosure relates to methods, apparatus, systems, and non-transitory computer-readable storage media for performing infield testing. Infield testing involves a deployment of infield testing firmware (FW) into a SoC. This infield testing FW executes infield tests using a high-level sequence of:
a) putting the SoC into a test mode,
b) executing one or more infield tests,
c) observing pass or fail signature(s) from the test(s); and
d) communicating to a host/user through a dashboard (local or cloud-based).

When an end user is faced with some issue, the SoC part is typically returned to the OEM and, if OEMs are not successful in debugging the issue, the part gets returned to the SoC maker. The returned part could have a logical defect, a structural defect with the hardware, or a defect with software/firmware execution. At this juncture, it is best for OEMs or SoC makers to classify whether the issue is related to a hardware defect, a microcontroller holding the infield firmware, or an infield firmware execution of the above sequence of steps.

Current automotive SoCs do not have the capability for an external debugger to acquire required information about 1) the progress of an infield test and/or 2) infield testing FW execution while the infield test is ongoing. This lack of capability delays finding a root cause of an issue and resolution of the issue. Further, today SoCs lack infield testing FW related debug hooks that are associated with infield testing for external debugger to observe. This lack of capability to probe into debug hooks prevents the OEM to determine a root cause an issue and hence OEMs must obtain support from its SoC supplier and generate an expensive field return.

Existing solutions consists of an infield testing FW controlling and executing infield test access without having a required observability to the external debugger. If there is a hang during an infield test execution and if there is no observability for debugger then this adds considerable complexity to the infield testing FW which limits scalable debug scenarios. There is additional complexity because, for each failure, there is a need for an additional infield testing FW patch to stop further infield test execution and help in root causing the issue. As automotive SoCs and server SoCs become complex, this is not going to be tenable as this approach requires considerable effort for patching FW multiple times in a trial-and-error manner and becomes difficult for OEMs to debug using such methods.

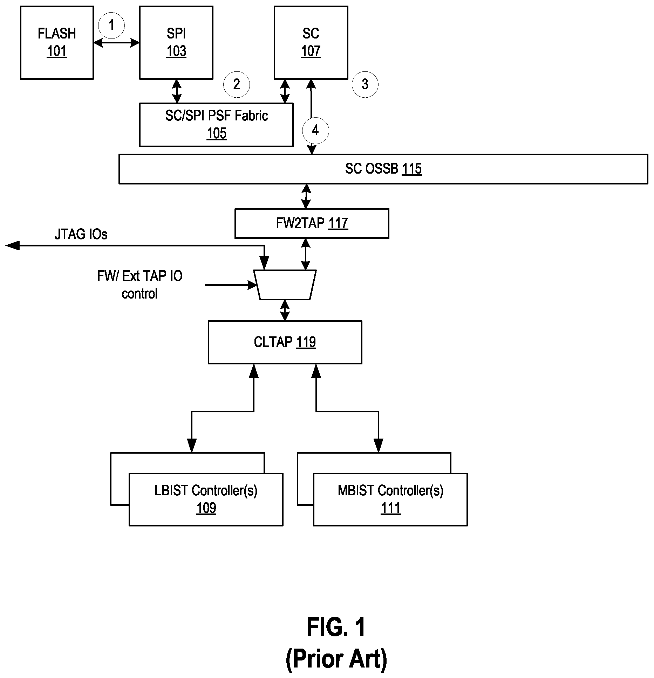

FIG. 1 illustrates examples of prior art data flow for infield testing. In some examples, a content image (e.g., instructions for a test) is stored in FLASH 101. A serial protocol interface (SPI) controller 103 fetches the image from the FLASH 101 at circle 1 and transfers it through a security controller (SC)/serial protocol interface (SPI) system bus 105 to the SC 107 at circle 2.

The SC 107 authenticates the image at circle 3 and transfers the image to the LBIST controller(s) 109 and/or MBIST controller(s) 111 at circle 4. In some examples, the SC 107 generates sideband command to be passed through a sideband bus (SC OSSB 115) to a FW to test access port (TAP) component 117 which converts the sideband command to tap commands. A chip-level TAP (CLTAP) 119 sends the tap commands to the LBIST controller(s) 109 and/or MBIST controller(s) 111 to run the test.

This has several disadvantages. First, when a part is returned to because of an infield test failure, the existing debugging methods intend to instrument the FW code with a "trial-and-error" method to first reproduce the problem in an independent environment and then fix it as noted above.

Second, as external parameters are controlled with different guard-bands, addressing the inaccuracy of the tooling equipment is to be accounted for as well resulting in a stack up of potential errors. An example of this parameter is the voltage to be supplied according to the temperature. In the customer environment the external parameters undergo variations and any testing has to address these variations without necessarily knowing what they are. As such, worst case scenarios are often evaluated.

Third, there are established proactive solutions to enable screening and remove defective part from being delivered, but when a return from the field occurs, successful root causing and correction depends on the reproducibility of the fault, independent of the environment. While each error reporting is a unique combination of environment, it is only when concurrent evidence is available that deeper analyses are engaged and where access to strong debugging capability is available.

Examples detailed herein allows for simultaneous and/or parallel access to an external debugger (e.g., via an 1149.1 Institute of Electrical and Electronics Engineers (IEEE) Joint Test Action Group (JTAG) interface) while infield firmware tests are in progress. This allows for greater insight (more granularity) and/or acceleration of testing (whether the issue is related to infield testing FW, an infield microcontroller, or a hardware defect).

When a part is returned for debugging because of failure in the field, it is important to execute the infield tests. While executing these infield tests, especially in a controlled environment, an observation of how the infield tests is progressing and knowing at what stage the test is having the issue may be important. This capability is not present with the existing solutions. Examples herein allow for data to be collected from the field and exposed to experts. This allows for the exploitation of the data closer to its production.

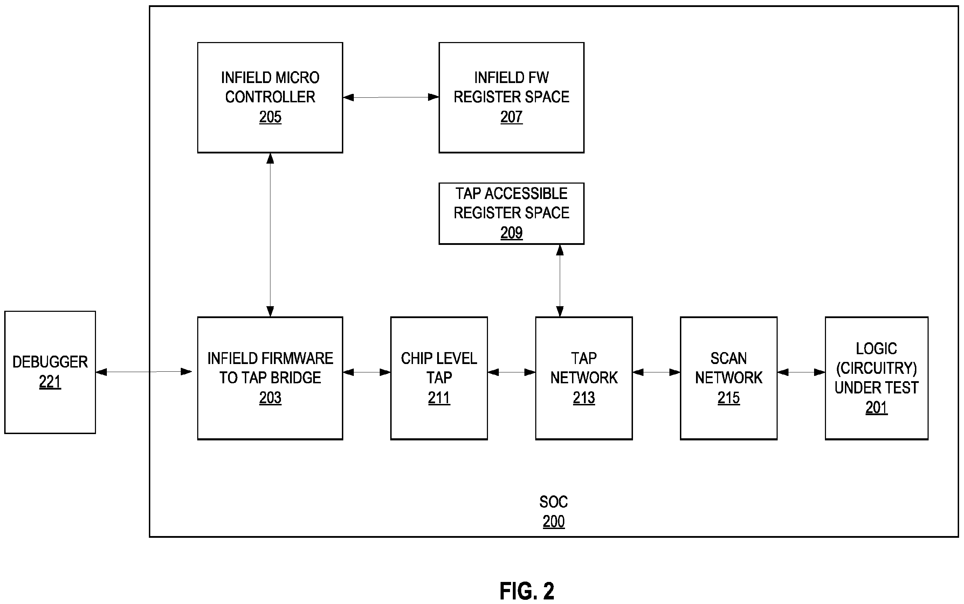

FIG. 2 illustrates examples of an architecture for allowing access to a TAP network by an external debugger and infield firmware. As shown, there are two register spaces that may be accessible to a debugger 221 - a TAP accessible register space 209 and an infield testing FW accessible register space 207. In some examples, the infield testing FW accessible register space 207 includes IFT control registers and debug/status registers. The IFT control registers are used to control a debug and the IFT debug/status registers are used to indicate the progress of infield tests. In some examples, both types of registers can be accessed by the infield testing FW 205 alone and/or by external debugger 221 alone or simultaneously by both.

As shown, the paths to get to the register spaces are different. For example, an infield microcontroller 205 (running or including infield testing FW) has access to the infield testing FW accessible register space 207, but would have to use the infield firmware to TAP bridge 203 (e.g., FW2TAP 117) to see the TAP accessible register space 209 (if allowed).

The infield firmware to TAP bridge 203 converts between protocols (e.g., from firmware to JTAG) and arbitrates between the infield testing FW and an external debug interface. A chip level TAP (CLTAP) 211 controls the TAP network 213 in which there is a network of child TAPs along with scan network 215.

The scan network 215 consists of a Logic Built In self-test (LBIST) controller that can execute scan tests (e.g., using input patterns applied to scan chains) and a Memory Built In self-test (MBIST) controller that can execute array tests (e.g., using patterns applied to memory and logged defects). These controllers couple to the TAP accessible registers 209.

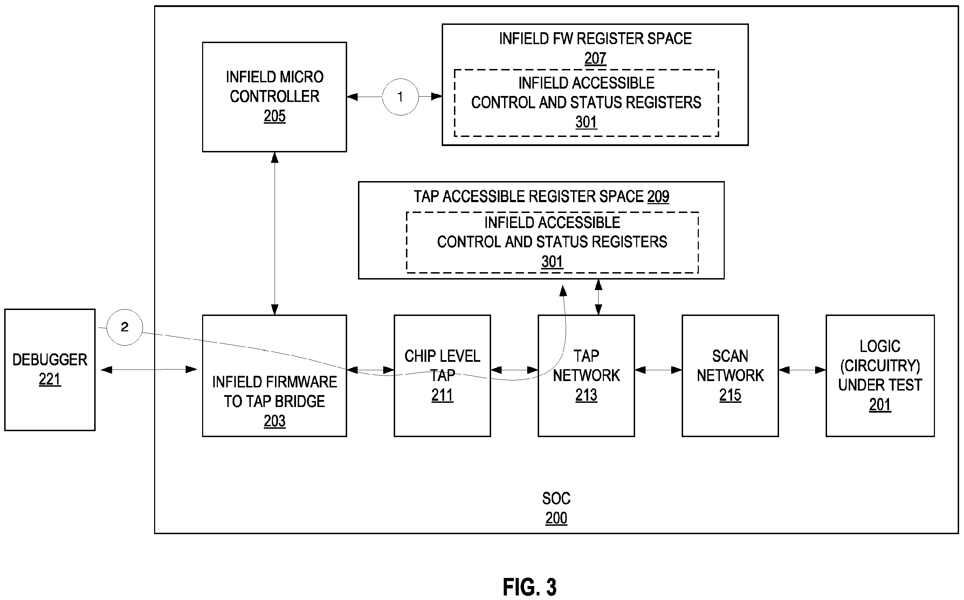

FIG. 3 illustrates examples of using an architecture for allowing access to a TAP network by an external debugger and infield firmware. Note that the reference numbers are the same as FIG. 2 and the components have the same functionality.

This illustration shows the infield accessible control and debug/status registers 301 as being mapped (shown as path 1) into the infield testing FW (memory mapped (MMIO)) register space 207 accessible by the infield microcontroller 205.

The infield accessible control and debug/status registers 301 are also mapped (shown as path 2) into the tap accessible register space 209 that is accessible by the external debugger 221.

When there are issues during debugging such as a signature mismatch, a hang, etc. encountered during infield test execution, this arrangement of register locations allows for the status or debug information to be collected through the external debug interface through the TAP 211. This arrangement may also be used to debug the progress of an infield test sequence because the external debugger 221 has the access to the infield accessible control and debug/status registers 301. Because infield control registers are exposed, the external debugger 221 also has the control on when to stop and re-start the infield test.

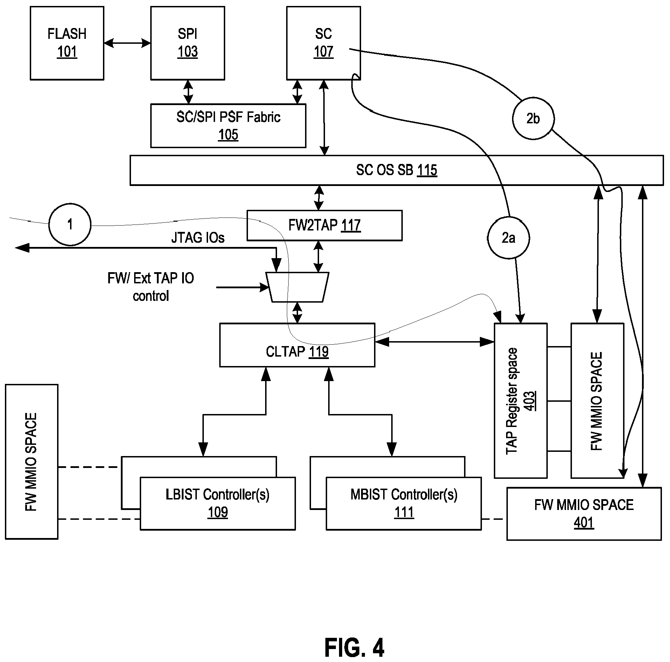

FIG. 4 illustrates examples of data flow for infield testing when the infield testing FW control and debug/status registers are duplicated in an infield testing register (FW MMIO) space 401 and tap accessible register space 403. Note the numbers of FIG. 1 are repeated and the operations are the same as that figure.

In some examples, a content image is stored in FLASH 101. A serial protocol interface (SPI) controller 103 fetches the image from the FLASH 101 and transfers it through a SC/SPI system bus 105 to the SC 107.

In some examples, the SC 107 authenticates the image and transfers the image to the LBIST controller(s) 109 and/or MBIST controller(s) 111. In some examples, the SC 107 generates sideband command to be passed through a sideband bus (SC OS SB 115) to a FW to test access port (TAP) component 117 which converts the sideband command to tap commands. A chip-level TAP 119 sends the tap commands to the LBIST controller(s) 109 and/or MBIST controller(s) 111 to run the test.

As shown, the IFT status and control of the debug registers are stored in the infield testing register (FW MMIO) space 401 and tap accessible register space 403. These spaces are independently configurable.

As shown, path 1 allows for an external debugger to access the TAP accessible register space 117. Paths 2a and 2b allow for the infield testing FW to access the infield testing register (FW MMIO) space 401.

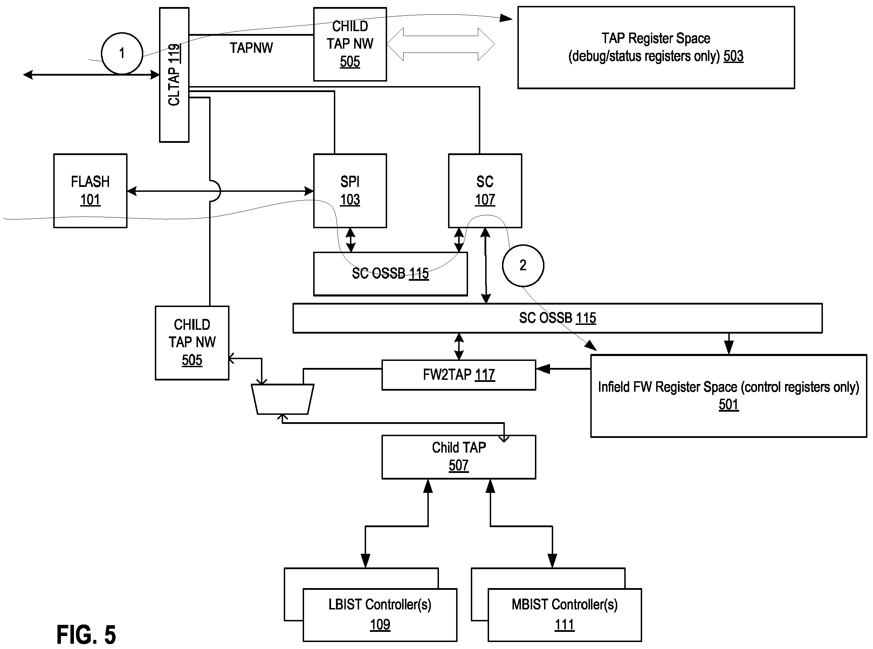

In some examples, the IFT control registers and IFT debug registers are selectively partitioned and mapped between the FW MMIO space and the TAP accessible registers space. FIG. 5 illustrates examples of selective IFT control registers and IFT debug registers partitioning. Two paths are created with this approach such that the external debugger has access to the infield testing registers related to debug/status in TAP register space 503 and the infield firmware can simultaneously access the registers related to control and debug/status in infield testing register (FW MMIO) space 503.

In particular, the external debugger (aka JTAG IO) goes through the CLTAP 119 through a child TAP network 505 to the TAP Accessible register space 503 holding infield testing registers related to debug and status. The firmware uses SPI Controller to pull the data from flash 101 and then passes it through the SC 107 which sends sideband commands through the IOSF Sideband Bus 115 to the IFT control registers in 501. The commands are converted to TAP commands using FW2TAP 117 to the start the scan test and array tests using the LBIST controller 109 and/or MBIST controller 111.

This approach provides flexibility to enable an external JTAG debugger with the ability to acquire the status of infield testing while infield testing FW has control over the IFT control registers. It is worth noting that although FIG. 4 has mapped all the IFT control and IFT debug into both spaces and in FIG. 5 has mapped differently, it is possible to optimize the register selection between two spaces based on the functionality and security level of the IFT control and debug registers. Example, a few control registers that have OEM security policy can be kept under a TAP register space and the debug registers that have other policies (e.g., restricted access to the OEM) can be placed under FW MMIO space. In other words, a mix can also be implemented as per the needs of the OEM/SoC use cases.

In some examples, the infield firmware to TAP bridge 203 (FW2TAP 117) arbitrates between the infield firmware 205 and the debugger 221. This is useful, if there is a hang observed or mismatch in the signature during infield test execution, as the external debugger can request the ownership of CLTAP so that the control of the TAP network will be with the external debug interface. The debugger then can read the infield test related debug registers in the TAP accessible register space to measure the progress of infield tests.

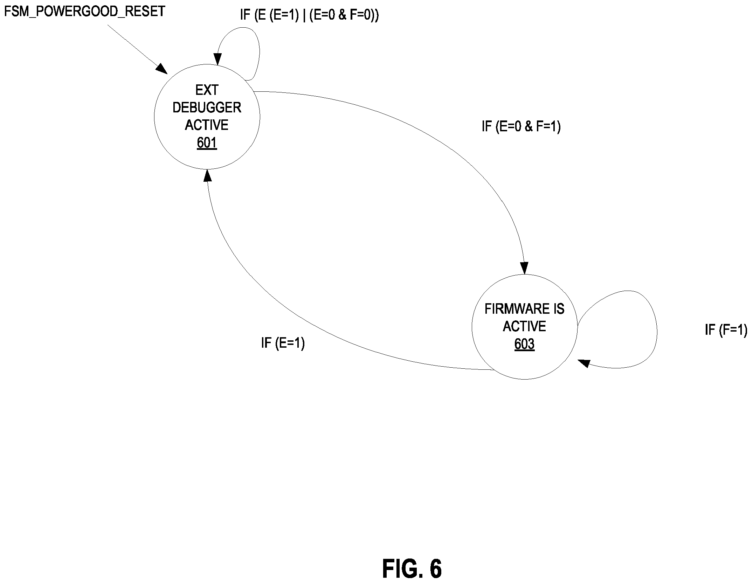

FIG. 6 illustrates examples of an arbitration finite state machine (FSM) used by the FW2TAP. In this figure, "E" stands for the external debugger requesting for access of the TAP network via the CLTAP, "F" stands for the infield testing FW requesting for access for the TAP network via the CLTAP. Out of reset the FSM enters a "External debugger is active" state. It remains in this state if E is 1 or both E and F are 0. The FSM transitions to a "Firmware is active" state when E= 0 and F = 1 and will remain in this state if F = 1.

With this arbitration in the FW2TAP provides the parallel access to the infield testing FW registers that are exposed only to OEM (protected under OEM security policy) and hence hangs related to infield testing can be debugged effectively and in an accelerated way.

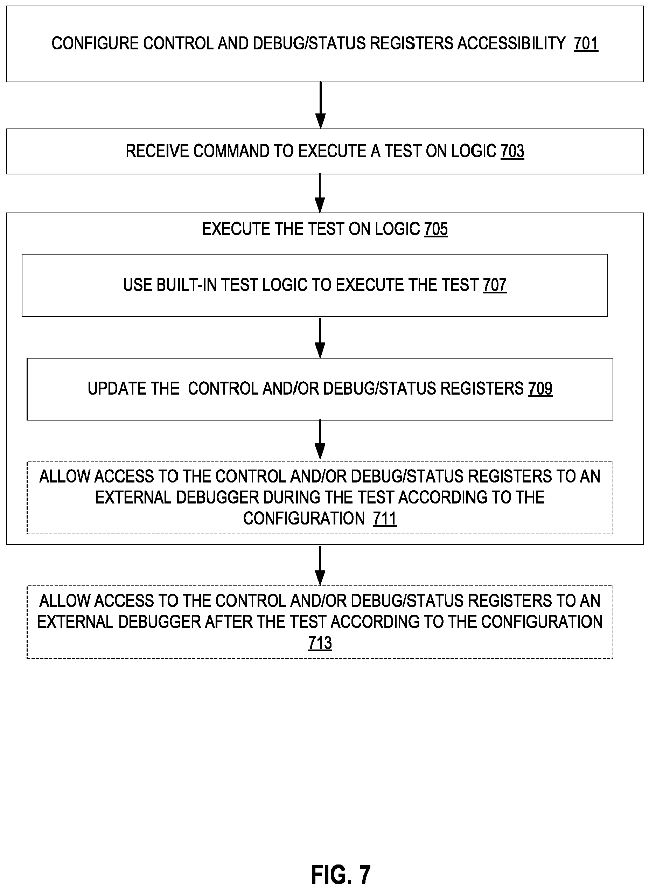

FIG. 7 illustrates examples of a method of using configurable IFT register allocation. At 701 control and debug/status registers accessibility is configured. For example, an external debugger may be used to configure how the registers are configured (where they are stored or duplicated). In some examples, this is a selection of a pre-programmed configuration.

A command to execute a test on logic is received at 703. This command may come from firmware or the external debugger. The command may include an indication to retrieve a test image, what controls to set in IFT control registers, what and when to output results (e.g., breaks), etc.

The test is executed on logic at 705. This execution uses built-in test logic to execute the test at 707. For example, one or more of the LBIST and MBIST are used. During execution one or more of the control and debug/status registers are updated at 709.

In some examples, access to the control and/or debug/status registers to an external debugger is allowed during the test according to the configuration at 711. For example, a hang has occurred and the test cannot be completed, so an external debugger grabs the debug/status register information.

In some examples, access to the control and/or debug/status registers to an external debugger after the test is allowed according to the configuration at 713.

Some examples are implemented in one or more computer architectures, cores, accelerators, etc. that are detailed below. Some examples are generated or are IP cores.

### Example Architectures

Detailed below are descriptions of example computer architectures. Other system designs and configurations known in the arts for laptop, desktop, and handheld personal computers (PC)s, personal digital assistants, engineering workstations, servers, disaggregated servers, network devices, network hubs, switches, routers, embedded processors, digital signal processors (DSPs), graphics devices, video game devices, set-top boxes, micro controllers, cell phones, portable media players, hand-held devices, and various other electronic devices, are also suitable. In general, a variety of systems or electronic devices capable of incorporating a processor and/or other execution logic as disclosed herein are generally suitable.

### Example Systems

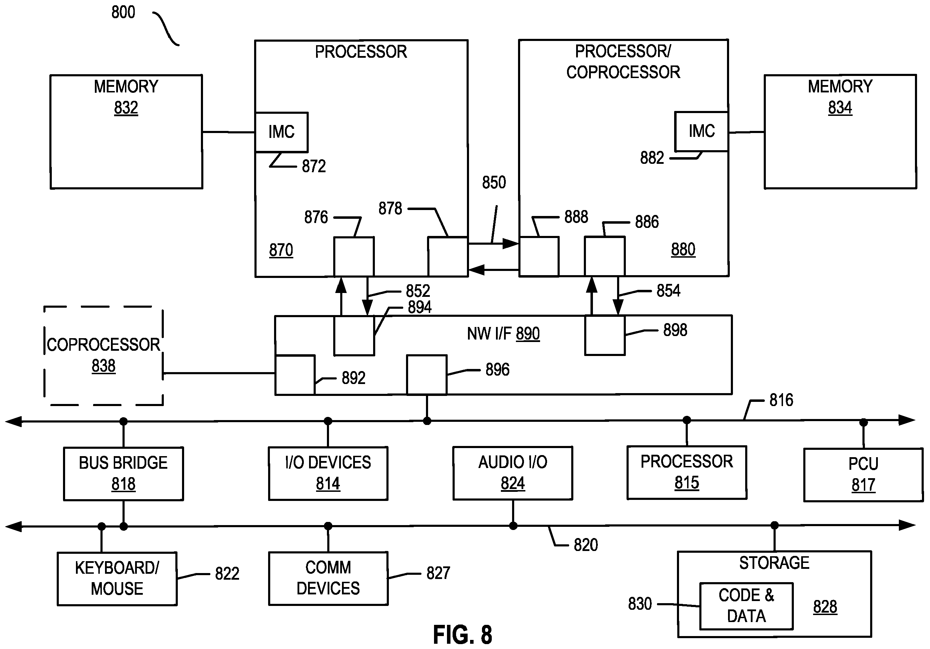

FIG. 8 illustrates an example computing system. Multiprocessor system 800 is an interfaced system and includes a plurality of processors or cores including a first processor 870 and a second processor 880 coupled via an interface 850 such as a point-to-point (P-P) interconnect, a fabric, and/or bus. In some examples, the first processor 870 and the second processor 880 are homogeneous. In some examples, first processor 870 and the second processor 880 are heterogenous. Though the example system 800 is shown to have two processors, the system may have three or more processors, or may be a single processor system. In some examples, the computing system is a system on a chip (SoC).

Processors 870 and 880 are shown including integrated memory controller (IMC) circuitry 872 and 882, respectively. Processor 870 also includes interface circuits 876 and 878; similarly, second processor 880 includes interface circuits 886 and 888. Processors 870, 880 may exchange information via the interface 850 using interface circuits 878, 888. IMCs 872 and 882 couple the processors 870, 880 to respective memories, namely a memory 832 and a memory 834, which may be portions of main memory locally attached to the respective processors.

Processors 870, 880 may each exchange information with a network interface (NW I/F) 890 via individual interfaces 852, 854 using interface circuits 876, 894, 886, 898. The network interface 890 (e.g., one or more of an interconnect, bus, and/or fabric, and in some examples is a chipset) may optionally exchange information with a coprocessor 838 via an interface circuit 892. In some examples, the coprocessor 838 is a special-purpose processor, such as, for example, a high-throughput processor, a network or communication processor, compression engine, graphics processor, general purpose graphics processing unit (GPGPU), neural-network processing unit (NPU), embedded processor, or the like.

A shared cache (not shown) may be included in either processor 870, 880 or outside of both processors, yet connected with the processors via an interface such as P-P interconnect, such that either or both processors' local cache information may be stored in the shared cache if a processor is placed into a low power mode.

Network interface 890 may be coupled to a first interface 816 via interface circuit 896. In some examples, first interface 816 may be an interface such as a Peripheral Component Interconnect (PCI) interconnect, a PCI Express interconnect or another I/O interconnect. In some examples, first interface 816 is coupled to a power control unit (PCU) 817, which may include circuitry, software, and/or firmware to perform power management operations with regard to the processors 870, 880 and/or co-processor 838. PCU 817 provides control information to a voltage regulator (not shown) to cause the voltage regulator to generate the appropriate regulated voltage. PCU 817 also provides control information to control the operating voltage generated. In various examples, PCU 817 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 817 is illustrated as being present as logic separate from the processor 870 and/or processor 880. In other cases, PCU 817 may execute on a given one or more of cores (not shown) of processor 870 or 880. In some cases, PCU 817 may be implemented as a microcontroller (dedicated or general-purpose) or other control logic configured to execute its own dedicated power management code, sometimes referred to as P-code. In yet other examples, power management operations to be performed by PCU 817 may be implemented externally to a processor, such as by way of a separate power management integrated circuit (PMIC) or another component external to the processor. In yet other examples, power management operations to be performed by PCU 817 may be implemented within BIOS or other system software.

Various I/O devices 814 may be coupled to first interface 816, along with a bus bridge 818 which couples first interface 816 to a second interface 820. In some examples, one or more additional processor(s) 815, such as coprocessors, high throughput many integrated core (MIC) processors, GPGPUs, accelerators (such as graphics accelerators or digital signal processing (DSP) units), field programmable gate arrays (FPGAs), or any other processor, are coupled to first interface 816. In some examples, second interface 820 may be a low pin count (LPC) interface. Various devices may be coupled to second interface 820 including, for example, a keyboard and/or mouse 822, communication devices 827 and storage circuitry 828. Storage circuitry 828 may be one or more non-transitory machine-readable storage media as described below, such as a disk drive or other mass storage device which may include instructions/code and data 830 and may implement the storage 803 in some examples. Further, an audio I/O 824 may be coupled to second interface 820. Note that other architectures than the point-to-point architecture described above are possible. For example, instead of the point-to-point architecture, a system such as multiprocessor system 800 may implement a multi-drop interface or other such architecture.

### Example Core Architectures, Processors, and Computer Architectures.

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput) computing. Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip (SoC) that may be included on the same die as the described CPU (sometimes referred to as the application core(s) or application processor(s)), the above described coprocessor, and additional functionality. Example core architectures are described next, followed by descriptions of example processors and computer architectures.

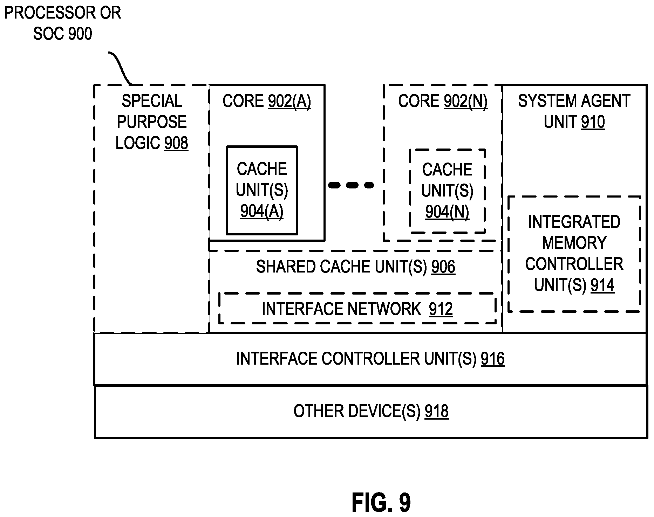

FIG. 9 illustrates a block diagram of an example processor and/or SoC 900 that may have one or more cores and an integrated memory controller. The solid lined boxes illustrate a processor 900 with a single core 902(A), system agent unit circuitry 910, and a set of one or more interface controller unit(s) circuitry 916, while the optional addition of the dashed lined boxes illustrates an alternative processor 900 with multiple cores 902(A)-(N), a set of one or more integrated memory controller unit(s) circuitry 914 in the system agent unit circuitry 910, and special purpose logic 908, as well as a set of one or more interface controller units circuitry 916. Note that the processor 900 may be one of the processors 870 or 880, or co-processor 838 or 815 of FIG. 8.

Thus, different implementations of the processor 900 may include: 1) a CPU with the special purpose logic 908 being integrated graphics and/or scientific (throughput) logic (which may include one or more cores, not shown), and the cores 902(A)-(N) being one or more general purpose cores (e.g., general purpose in-order cores, general purpose out-of-order cores, or a combination of the two); 2) a coprocessor with the cores 902(A)-(N) being a large number of special purpose cores intended primarily for graphics and/or scientific (throughput); and 3) a coprocessor with the cores 902(A)-(N) being a large number of general purpose in-order cores. Thus, the processor 900 may be a general-purpose processor, coprocessor or special-purpose processor, such as, for example, a network or communication processor, compression engine, graphics processor, GPGPU (general purpose graphics processing unit), a high throughput many integrated core (MIC) coprocessor (including 30 or more cores), embedded processor, or the like. The processor may be implemented on one or more chips. The processor 900 may be a part of and/or may be implemented on one or more substrates using any of a number of process technologies, such as, for example, complementary metal oxide semiconductor (CMOS), bipolar CMOS (BiCMOS), P-type metal oxide semiconductor (PMOS), or N-type metal oxide semiconductor (NMOS).

A memory hierarchy includes one or more levels of cache unit(s) circuitry 904(A)-(N) within the cores 902(A)-(N), a set of one or more shared cache unit(s) circuitry 906, and external memory (not shown) coupled to the set of integrated memory controller unit(s) circuitry 914. The set of one or more shared cache unit(s) circuitry 906 may include one or more mid-level caches, such as level 2 (L2), level 3 (L3), level 4 (L4), or other levels of cache, such as a last level cache (LLC), and/or combinations thereof. While in some examples interface network circuitry 912 (e.g., a ring interconnect) interfaces the special purpose logic 908 (e.g., integrated graphics logic), the set of shared cache unit(s) circuitry 906, and the system agent unit circuitry 910, alternative examples use any number of well-known techniques for interfacing such units. In some examples, coherency is maintained between one or more of the shared cache unit(s) circuitry 906 and cores 902(A)-(N). In some examples, interface controller units circuitry 916 couple the cores 902 to one or more other devices 918 such as one or more I/O devices, storage, one or more communication devices (e.g., wireless networking, wired networking, etc.), etc.

In some examples, one or more of the cores 902(A)-(N) are capable of multi-threading. The system agent unit circuitry 910 includes those components coordinating and operating cores 902(A)-(N). The system agent unit circuitry 910 may include, for example, power control unit (PCU) circuitry and/or display unit circuitry (not shown). The PCU may be or may include logic and components needed for regulating the power state of the cores 902(A)-(N) and/or the special purpose logic 908 (e.g., integrated graphics logic). The display unit circuitry is for driving one or more externally connected displays.

The cores 902(A)-(N) may be homogenous in terms of instruction set architecture (ISA). Alternatively, the cores 902(A)-(N) may be heterogeneous in terms of ISA; that is, a subset of the cores 902(A)-(N) may be capable of executing an ISA, while other cores may be capable of executing only a subset of that ISA or another ISA.

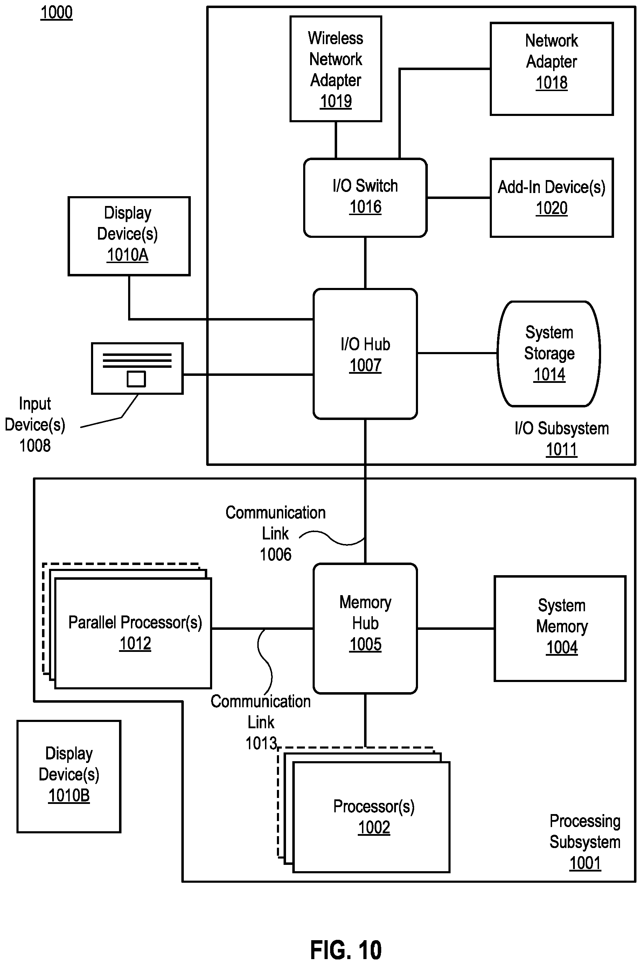

FIG. 10 is a block diagram illustrating a computing system 1000 configured to implement one or more aspects of the examples described herein. The computing system 1000 includes a processing subsystem 1001 having one or more processor(s) 1002 and a system memory 1004 communicating via an interconnection path that may include a memory hub 1005. The memory hub 1005 may be a separate component within a chipset component or may be integrated within the one or more processor(s) 1002. The memory hub 1005 couples with an I/O subsystem 1011 via a communication link 1006. The I/O subsystem 1011 includes an I/O hub 1007 that can enable the computing system 1000 to receive input from one or more input device(s) 1008. Additionally, the I/O hub 1007 can enable a display controller, which may be included in the one or more processor(s) 1002, to provide outputs to one or more display device(s) 1010A. In some examples the one or more display device(s) 1010A coupled with the I/O hub 1007 can include a local, internal, or embedded display device.

The processing subsystem 1001, for example, includes one or more parallel processor(s) 1012 coupled to memory hub 1005 via a bus or other communication link 1013. The communication link 1013 may be one of any number of standards-based communication link technologies or protocols, such as, but not limited to PCI Express, or may be a vendor specific communications interface or communications fabric. The one or more parallel processor(s) 1012 may form a computationally focused parallel or vector processing system that can include a large number of processing cores and/or processing clusters, such as a many integrated core (MIC) processor. For example, the one or more parallel processor(s) 1012 form a graphics processing subsystem that can output pixels to one of the one or more display device(s) 1010A coupled via the I/O hub 1007. The one or more parallel processor(s) 1012 can also include a display controller and display interface (not shown) to enable a direct connection to one or more display device(s) 1010B.

Within the I/O subsystem 1011, a system storage unit 1014 can connect to the I/O hub 1007 to provide a storage mechanism for the computing system 1000. An I/O switch 1016 can be used to provide an interface mechanism to enable connections between the I/O hub 1007 and other components, such as a network adapter 1018 and/or wireless network adapter 1019 that may be integrated into the platform, and various other devices that can be added via one or more add-in device(s) 1020. The add-in device(s) 1020 may also include, for example, one or more external graphics processor devices, graphics cards, and/or compute accelerators. The network adapter 1018 can be an Ethernet adapter or another wired network adapter. The wireless network adapter 1019 can include one or more of a Wi-Fi, Bluetooth, near field communication (NFC), or other network device that includes one or more wireless radios.

The computing system 1000 can include other components not explicitly shown, including USB or other port connections, optical storage drives, video capture devices, and the like, which may also be connected to the I/O hub 1007. Communication paths interconnecting the various components in FIG. 10 may be implemented using any suitable protocols, such as PCI (Peripheral Component Interconnect) based protocols (e.g., PCI-Express), or any other bus or point-to-point communication interfaces and/or protocol(s), such as the NVLink high-speed interconnect, Compute Express Link^{™} (CXL^{™}) (e.g., CXL.mem), Infinity Fabric (IF), Ethernet (IEEE 802.3), remote direct memory access (RDMA), InfiniBand, Internet Wide Area RDMA Protocol (iWARP), Transmission Control Protocol (TCP), User Datagram Protocol (UDP), quick UDP Internet Connections (QUIC), RDMA over Converged Ethernet (RoCE), Intel QuickPath Interconnect (QPI), Intel Ultra Path Interconnect (UPI), Intel On-Chip System Fabric (IOSF), Omnipath, HyperTransport, Advanced Microcontroller Bus Architecture (AMBA) interconnect, OpenCAPI, Gen-Z, Cache Coherent Interconnect for Accelerators (CClX), 3GPP Long Term Evolution (LTE) (4G), 3GPP 5G, and variations thereof, or wired or wireless interconnect protocols known in the art. In some examples, data can be copied or stored to virtualized storage nodes using a protocol such as non-volatile memory express (NVMe) over Fabrics (NVMe-oF) or NVMe.

The one or more parallel processor(s) 1012 may incorporate circuitry optimized for graphics and video processing, including, for example, video output circuitry, and constitutes a graphics processing unit (GPU). Alternatively or additionally, the one or more parallel processor(s) 1012 can incorporate circuitry optimized for general purpose processing, while preserving the underlying computational architecture, described in greater detail herein. Components of the computing system 1000 may be integrated with one or more other system elements on a single integrated circuit. For example, the one or more parallel processor(s) 1012, memory hub 1005, processor(s) 1002, and I/O hub 1007 can be integrated into a system on chip (SoC) integrated circuit. Alternatively, the components of the computing system 1000 can be integrated into a single package to form a system in package (SIP) configuration. In some examples at least a portion of the components of the computing system 1000 can be integrated into a multi-chip module (MCM), which can be interconnected with other multi-chip modules into a modular computing system.

It will be appreciated that the computing system 1000 shown herein is illustrative and that variations and modifications are possible. The connection topology, including the number and arrangement of bridges, the number of processor(s) 1002, and the number of parallel processor(s) 1012, may be modified as desired. For instance, system memory 1004 can be connected to the processor(s) 1002 directly rather than through a bridge, while other devices communicate with system memory 1004 via the memory hub 1005 and the processor(s) 1002. In other alternative topologies, the parallel processor(s) 1012 are connected to the I/O hub 1007 or directly to one of the one or more processor(s) 1002, rather than to the memory hub 1005. In other examples, the I/O hub 1007 and memory hub 1005 may be integrated into a single chip. It is also possible that two or more sets of processor(s) 1002 are attached via multiple sockets, which can couple with two or more instances of the parallel processor(s) 1012.

Some of the particular components shown herein are optional and may not be included in all implementations of the computing system 1000. For example, any number of add-in cards or peripherals may be supported, or some components may be eliminated. Furthermore, some architectures may use different terminology for components similar to those illustrated in FIG. 10. For example, the memory hub 1005 may be referred to as a Northbridge in some architectures, while the I/O hub 1007 may be referred to as a Southbridge.

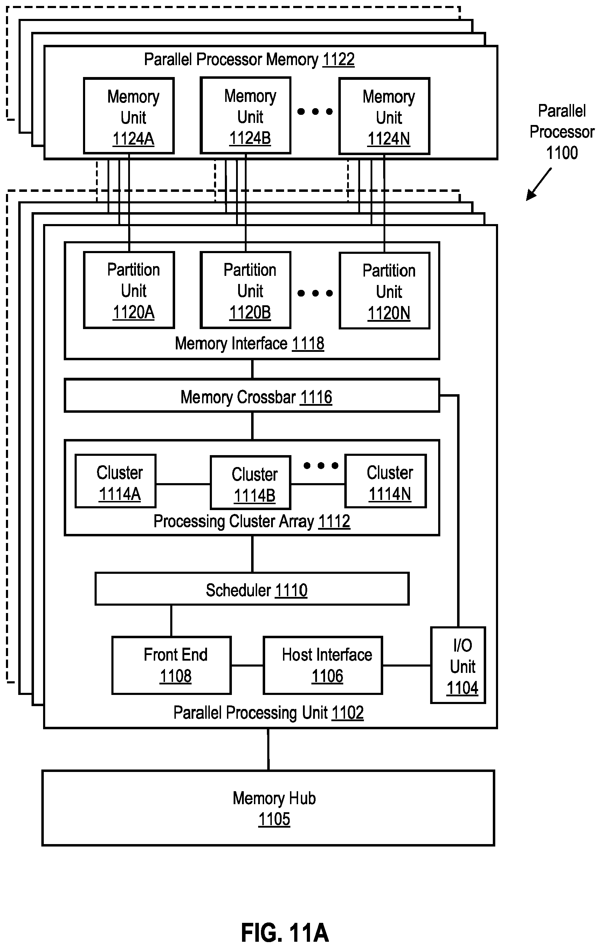

FIG. 11A illustrates examples of a parallel processor 1100. The parallel processor 1100 may be a GPU, GPGPU or the like as described herein. The various components of the parallel processor 1100 may be implemented using one or more integrated circuit devices, such as programmable processors, application specific integrated circuits (ASICs), or field programmable gate arrays (FPGA). The illustrated parallel processor 1100 may be one or more of the parallel processor(s) 1012 shown in FIG. 10.

The parallel processor 1100 includes a parallel processing unit 1102. The parallel processing unit includes an I/O unit 1104 that enables communication with other devices, including other instances of the parallel processing unit 1102. The I/O unit 1104 may be directly connected to other devices. For instance, the I/O unit 1104 connects with other devices via the use of a hub or switch interface, such as memory hub 1005. The connections between the memory hub 1005 and the I/O unit 1104 form a communication link 1013. Within the parallel processing unit 1102, the I/O unit 1104 connects with a host interface 1106 and a memory crossbar 1116, where the host interface 1106 receives commands directed to performing processing operations and the memory crossbar 1116 receives commands directed to performing memory operations.

When the host interface 1106 receives a command buffer via the I/O unit 1104, the host interface 1106 can direct work operations to perform those commands to a front end 1108. In some examples the front end 1108 couples with a scheduler 1110, which is configured to distribute commands or other work items to a processing cluster array 1112. The scheduler 1110 ensures that the processing cluster array 1112 is properly configured and in a valid state before tasks are distributed to the processing clusters of the processing cluster array 1112. The scheduler 1110 may be implemented via firmware logic executing on a microcontroller. The microcontroller implemented scheduler 1110 is configurable to perform complex scheduling and work distribution operations at coarse and fine granularity, enabling rapid preemption and context switching of threads executing on the processing cluster array 1112. Preferably, the host software can prove workloads for scheduling on the processing cluster array 1112 via one of multiple graphics processing doorbells. In other examples, polling for new workloads or interrupts can be used to identify or indicate availability of work to perform. The workloads can then be automatically distributed across the processing cluster array 1112 by the scheduler 1110 logic within the scheduler microcontroller.

The processing cluster array 1112 can include up to "N" processing clusters (e.g., cluster 1114A, cluster 1114B, through cluster 1114N). Each cluster 1114A-1114N of the processing cluster array 1112 can execute a large number of concurrent threads. The scheduler 1110 can allocate work to the clusters 1114A-1114N of the processing cluster array 1112 using various scheduling and/or work distribution algorithms, which may vary depending on the workload arising for each type of program or computation. The scheduling can be handled dynamically by the scheduler 1110 or can be assisted in part by compiler logic during compilation of program logic configured for execution by the processing cluster array 1112. Optionally, different clusters 1114A-1114N of the processing cluster array 1112 can be allocated for processing different types of programs or for performing different types of computations.

The processing cluster array 1112 can be configured to perform various types of parallel processing operations. For example, the processing cluster array 1112 is configured to perform general-purpose parallel compute operations. For example, the processing cluster array 1112 can include logic to execute processing tasks including filtering of video and/or audio data, performing modeling operations, including physics operations, and performing data transformations.

The processing cluster array 1112 is configured to perform parallel graphics processing operations. In such examples in which the parallel processor 1100 is configured to perform graphics processing operations, the processing cluster array 1112 can include additional logic to support the execution of such graphics processing operations, including, but not limited to texture sampling logic to perform texture operations, as well as tessellation logic and other vertex processing logic. Additionally, the processing cluster array 1112 can be configured to execute graphics processing related shader programs such as, but not limited to vertex shaders, tessellation shaders, geometry shaders, and pixel shaders. The parallel processing unit 1102 can transfer data from system memory via the I/O unit 1104 for processing. During processing the transferred data can be stored to on-chip memory (e.g., parallel processor memory 1122) during processing, then written back to system memory.

In examples in which the parallel processing unit 1102 is used to perform graphics processing, the scheduler 1110 may be configured to divide the processing workload into approximately equal sized tasks, to better enable distribution of the graphics processing operations to multiple clusters 1114A-1114N of the processing cluster array 1112. In some of these examples, portions of the processing cluster array 1112 can be configured to perform different types of processing. For example, a first portion may be configured to perform vertex shading and topology generation, a second portion may be configured to perform tessellation and geometry shading, and a third portion may be configured to perform pixel shading or other screen space operations, to produce a rendered image for display. Intermediate data produced by one or more of the clusters 1114A-1114N may be stored in buffers to allow the intermediate data to be transmitted between clusters 1114A-1114N for further processing.

During operation, the processing cluster array 1112 can receive processing tasks to be executed via the scheduler 1110, which receives commands defining processing tasks from front end 1108. For graphics processing operations, processing tasks can include indices of data to be processed, e.g., surface (patch) data, primitive data, vertex data, and/or pixel data, as well as state parameters and commands defining how the data is to be processed (e.g., what program is to be executed). The scheduler 1110 may be configured to fetch the indices corresponding to the tasks or may receive the indices from the front end 1108. The front end 1108 can be configured to ensure the processing cluster array 1112 is configured to a valid state before the workload specified by incoming command buffers (e.g., batch-buffers, push buffers, etc.) is initiated.

Each of the one or more instances of the parallel processing unit 1102 can couple with parallel processor memory 1122. The parallel processor memory 1122 can be accessed via the memory crossbar 1116, which can receive memory requests from the processing cluster array 1112 as well as the I/O unit 1104. The memory crossbar 1116 can access the parallel processor memory 1122 via a memory interface 1118. The memory interface 1118 can include multiple partition units (e.g., partition unit 1120A, partition unit 1120B, through partition unit 1120N) that can each couple to a portion (e.g., memory unit) of parallel processor memory 1122. The number of partition units 1120A-1120N may be configured to be equal to the number of memory units, such that a first partition unit 1120A has a corresponding first memory unit 1124A, a second partition unit 1120B has a corresponding second memory unit 1124B, and an Nth partition unit 1120N has a corresponding Nth memory unit 1124N. In other examples, the number of partition units 1120A-1120N may not be equal to the number of memory devices.

The memory units 1124A-1124N can include various types of memory devices, including dynamic random-access memory (DRAM) or graphics random access memory, such as synchronous graphics random access memory (SGRAM), including graphics double data rate (GDDR) memory. Optionally, the memory units 1124A-1124N may also include 3D stacked memory, including but not limited to high bandwidth memory (HBM). Persons skilled in the art will appreciate that the specific implementation of the memory units 1124A-1124N can vary and can be selected from one of various conventional designs. Render targets, such as frame buffers or texture maps may be stored across the memory units 1124A-1124N, allowing partition units 1120A-1120N to write portions of each render target in parallel to efficiently use the available bandwidth of parallel processor memory 1122. In some examples, a local instance of the parallel processor memory 1122 may be excluded in favor of a unified memory design that utilizes system memory in conjunction with local cache memory.

Optionally, any one of the clusters 1114A-1114N of the processing cluster array 1112 has the ability to process data that will be written to any of the memory units 1124A-1124N within parallel processor memory 1122. The memory crossbar 1116 can be configured to transfer the output of each cluster 1114A-1114N to any partition unit 1120A-1120N or to another cluster 1114A-1114N, which can perform additional processing operations on the output. Each cluster 1114A-1114N can communicate with the memory interface 1118 through the memory crossbar 1116 to read from or write to various external memory devices. In one of the examples with the memory crossbar 1116 the memory crossbar 1116 has a connection to the memory interface 1118 to communicate with the I/O unit 1104, as well as a connection to a local instance of the parallel processor memory 1122, enabling the processing units within the different processing clusters 1114A-1114N to communicate with system memory or other memory that is not local to the parallel processing unit 1102. Generally, the memory crossbar 1116 may, for example, be able to use virtual channels to separate traffic streams between the clusters 1114A-1114N and the partition units 1120A-1120N.

While a single instance of the parallel processing unit 1102 is illustrated within the parallel processor 1100, any number of instances of the parallel processing unit 1102 can be included. For example, multiple instances of the parallel processing unit 1102 can be provided on a single add-in card, or multiple add-in cards can be interconnected. For example, the parallel processor 1100 can be an add-in device, such as add-in device 1020 of FIG. 10, which may be a graphics card such as a discrete graphics card that includes one or more GPUs, one or more memory devices, and device-to-device or network or fabric interfaces. The different instances of the parallel processing unit 1102 can be configured to inter-operate even if the different instances have different numbers of processing cores, different amounts of local parallel processor memory, and/or other configuration differences. Optionally, some instances of the parallel processing unit 1102 can include higher precision floating point units relative to other instances. Systems incorporating one or more instances of the parallel processing unit 1102 or the parallel processor 1100 can be implemented in a variety of configurations and form factors, including but not limited to desktop, laptop, or handheld personal computers, servers, workstations, game consoles, and/or embedded systems. An orchestrator can form composite nodes for workload performance using one or more of: disaggregated processor resources, cache resources, memory resources, storage resources, and networking resources.

In some examples, the parallel processing unit 1102 can be partitioned into multiple instances. Those multiple instances can be configured to execute workloads associated with different clients in an isolated manner, enabling a pre-determined quality of service to be provided for each client. For example, each cluster 1114A-1114N can be compartmentalized and isolated from other clusters, allowing the processing cluster array 1112 to be divided into multiple compute partitions or instances. In such configuration, workloads that execute on an isolated partition are protected from faults or errors associated with a different workload that executes on a different partition. The partition units 1120A-1120N can be configured to enable a dedicated and/or isolated path to memory for the clusters 1114A-1114N associated with the respective compute partitions. This datapath isolation enables the compute resources within a partition can communicate with one or more assigned memory units 1124A-1124N without being subjected to inference by the activities of other partitions.

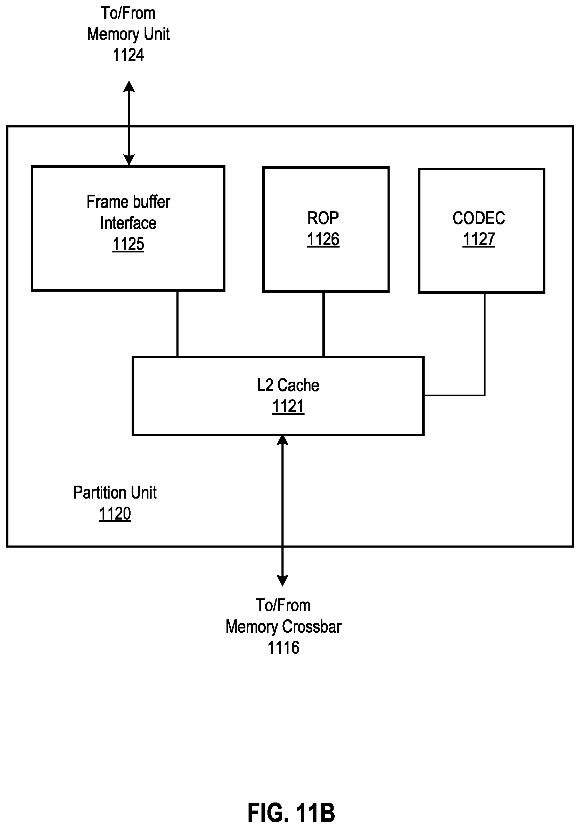

FIG. 11B is a block diagram of a partition unit 1120. The partition unit 1120 may be an instance of one of the partition units 1120A-1120N of FIG. 11A. As illustrated, the partition unit 1120 includes an L2 cache 1121, a frame buffer interface 1125, and a ROP 1126 (raster operations unit). The L2 cache 1121 is a read/write cache that is configured to perform load and store operations received from the memory crossbar 1116 and ROP 1126. Read misses and urgent write-back requests are output by L2 cache 1121 to frame buffer interface 1125 for processing. Updates can also be sent to the frame buffer via the frame buffer interface 1125 for processing. In some examples the frame buffer interface 1125 interfaces with one of the memory units in parallel processor memory, such as the memory units 1124A-1124N of FIG. 11A (e.g., within parallel processor memory 1122). The partition unit 1120 may additionally or alternatively also interface with one of the memory units in parallel processor memory via a memory controller (not shown).

In graphics applications, the ROP 1126 is a processing unit that performs raster operations such as stencil, z test, blending, and the like. The ROP 1126 then outputs processed graphics data that is stored in graphics memory. In some examples the ROP 1126 includes or couples with a CODEC 1127 that includes compression logic to compress depth or color data that is written to memory or the L2 cache 1121 and decompress depth or color data that is read from memory or the L2 cache 1121. The compression logic can be lossless compression logic that makes use of one or more of multiple compression algorithms. The type of compression that is performed by the CODEC 1127 can vary based on the statistical characteristics of the data to be compressed. For example, in some examples, delta color compression is performed on depth and color data on a per-tile basis. In some examples the CODEC 1127 includes compression and decompression logic that can compress and decompress compute data associated with machine learning operations. The CODEC 1127 can, for example, compress sparse matrix data for sparse machine learning operations. The CODEC 1127 can also compress sparse matrix data that is encoded in a sparse matrix format (e.g., coordinate list encoding (COO), compressed sparse row (CSR), compress sparse column (SC), etc.) to generate compressed and encoded sparse matrix data. The compressed and encoded sparse matrix data can be decompressed and/or decoded before being processed by processing elements or the processing elements can be configured to consume compressed, encoded, or compressed and encoded data for processing.

The ROP 1126 may be included within each processing cluster (e.g., cluster 1114A-1114N of FIG. 11A) instead of within the partition unit 1120. In such example, read and write requests for pixel data are transmitted over the memory crossbar 1116 instead of pixel fragment data. The processed graphics data may be displayed on a display device, such as one of the one or more display device(s) 1010A-1010B of FIG. 10, routed for further processing by the processor(s) 1002, or routed for further processing by one of the processing entities within the parallel processor 1100 of FIG. 11A.

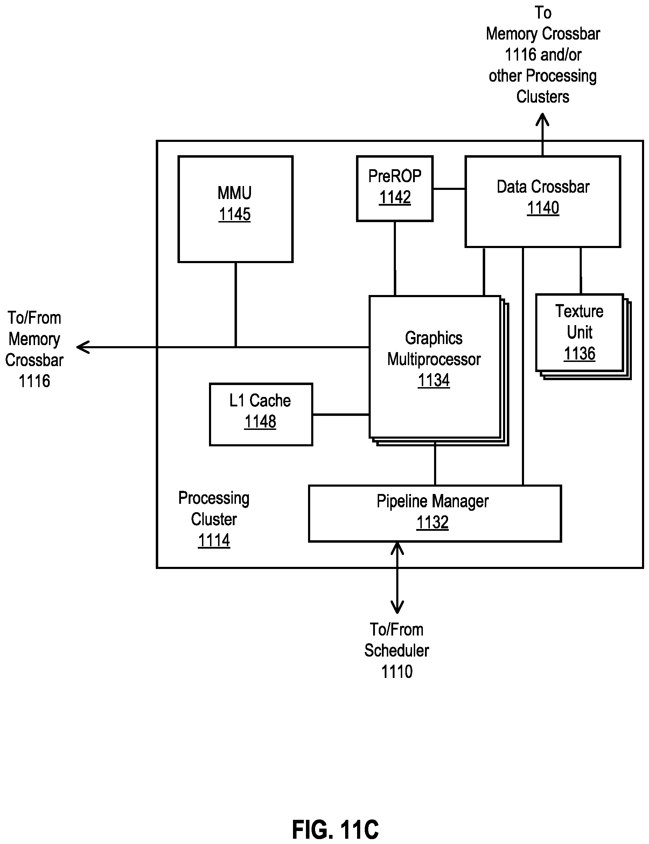

FIG. 11C is a block diagram of a processing cluster 1114 within a parallel processing unit. For example, the processing cluster is an instance of one of the processing clusters 1114A-1114N of FIG. 11A. The processing cluster 1114 can be configured to execute many threads in parallel, where the term "thread" refers to an instance of a particular program executing on a particular set of input data. Optionally, single-instruction, multiple-data (SIMD) instruction issue techniques may be used to support parallel execution of a large number of threads without providing multiple independent instruction units. Alternatively, single-instruction, multiple-thread (SIMT) techniques may be used to support parallel execution of a large number of generally synchronized threads, using a common instruction unit configured to issue instructions to a set of processing engines within each one of the processing clusters. Unlike a SIMD execution regime, where all processing engines typically execute identical instructions, SIMT execution allows different threads to more readily follow divergent execution paths through a given thread program. Persons skilled in the art will understand that a SIMD processing regime represents a functional subset of a SIMT processing regime.

Operation of the processing cluster 1114 can be controlled via a pipeline manager 1132 that distributes processing tasks to SIMT parallel processors. The pipeline manager 1132 receives instructions from the scheduler 1110 of FIG. 11A and manages execution of those instructions via a graphics multiprocessor 1134 and/or a texture unit 1136. The illustrated graphics multiprocessor 1134 is an exemplary instance of a SIMT parallel processor. However, various types of SIMT parallel processors of differing architectures may be included within the processing cluster 1114. One or more instances of the graphics multiprocessor 1134 can be included within a processing cluster 1114. The graphics multiprocessor 1134 can process data and a data crossbar 1140 can be used to distribute the processed data to one of multiple possible destinations, including other shader units. The pipeline manager 1132 can facilitate the distribution of processed data by specifying destinations for processed data to be distributed via the data crossbar 1140.

Each graphics multiprocessor 1134 within the processing cluster 1114 can include an identical set of functional execution logic (e.g., arithmetic logic units, load-store units, etc.). The functional execution logic can be configured in a pipelined manner in which new instructions can be issued before previous instructions are complete. The functional execution logic supports a variety of operations including integer and floating-point arithmetic, comparison operations, Boolean operations, bit-shifting, and computation of various algebraic functions. The same functional-unit hardware could be leveraged to perform different operations and any combination of functional units may be present.

The instructions transmitted to the processing cluster 1114 constitute a thread. A set of threads executing across the set of parallel processing engines is a thread group. A thread group executes the same program on different input data. Each thread within a thread group can be assigned to a different processing engine within a graphics multiprocessor 1134. A thread group may include fewer threads than the number of processing engines within the graphics multiprocessor 1134. When a thread group includes fewer threads than the number of processing engines, one or more of the processing engines may be idle during cycles in which that thread group is being processed. A thread group may also include more threads than the number of processing engines within the graphics multiprocessor 1134. When the thread group includes more threads than the number of processing engines within the graphics multiprocessor 1134, processing can be performed over consecutive clock cycles. Optionally, multiple thread groups can be executed concurrently on the graphics multiprocessor 1134.

The graphics multiprocessor 1134 may include an internal cache memory to perform load and store operations. Optionally, the graphics multiprocessor 1134 can forego an internal cache and use a cache memory (e.g., level 1 (L1) cache 1148) within the processing cluster 1114. Each graphics multiprocessor 1134 also has access to level 2 (L2) caches within the partition units (e.g., partition units 1120A-1120N of FIG. 11A) that are shared among all processing clusters 1114 and may be used to transfer data between threads. The graphics multiprocessor 1134 may also access off-chip global memory, which can include one or more of local parallel processor memory and/or system memory. Any memory external to the parallel processing unit 1102 may be used as global memory. Embodiments in which the processing cluster 1114 includes multiple instances of the graphics multiprocessor 1134 can share common instructions and data, which may be stored in the L1 cache 1148.

Each processing cluster 1114 may include an MMU 1145 (memory management unit) that is configured to map virtual addresses into physical addresses. In other examples, one or more instances of the MMU 1145 may reside within the memory interface 1118 of FIG. 11A. The MMU 1145 includes a set of page table entries (PTEs) used to map a virtual address to a physical address of a tile and optionally a cache line index. The MMU 1145 may include address translation lookaside buffers (TLB) or caches that may reside within the graphics multiprocessor 1134 or the L1 cache 1148 of processing cluster 1114. The physical address is processed to distribute surface data access locality to allow efficient request interleaving among partition units. The cache line index may be used to determine whether a request for a cache line is a hit or miss.

In graphics and computing applications, a processing cluster 1114 may be configured such that each graphics multiprocessor 1134 is coupled to a texture unit 1136 for performing texture mapping operations, e.g., determining texture sample positions, reading texture data, and filtering the texture data. Texture data is read from an internal texture L1 cache (not shown) or in some examples from the L1 cache within graphics multiprocessor 1134 and is fetched from an L2 cache, local parallel processor memory, or system memory, as needed. Each graphics multiprocessor 1134 outputs processed tasks to the data crossbar 1140 to provide the processed task to another processing cluster 1114 for further processing or to store the processed task in an L2 cache, local parallel processor memory, or system memory via the memory crossbar 1116. A preROP 1142 (pre-raster operations unit) is configured to receive data from graphics multiprocessor 1134, direct data to ROP units, which may be located with partition units as described herein (e.g., partition units 1120A-1120N of FIG. 11A). The preROP 1142 unit can perform optimizations for color blending, organize pixel color data, and perform address translations.

It will be appreciated that the core architecture described herein is illustrative and that variations and modifications are possible. Any number of processing units, e.g., graphics multiprocessor 1134, texture units 1136, preROPs 1142, etc., may be included within a processing cluster 1114. Further, while only one processing cluster 1114 is shown, a parallel processing unit as described herein may include any number of instances of the processing cluster 1114. Optionally, each processing cluster 1114 can be configured to operate independently of other processing clusters 1114 using separate and distinct processing units, L1 caches, L2 caches, etc.

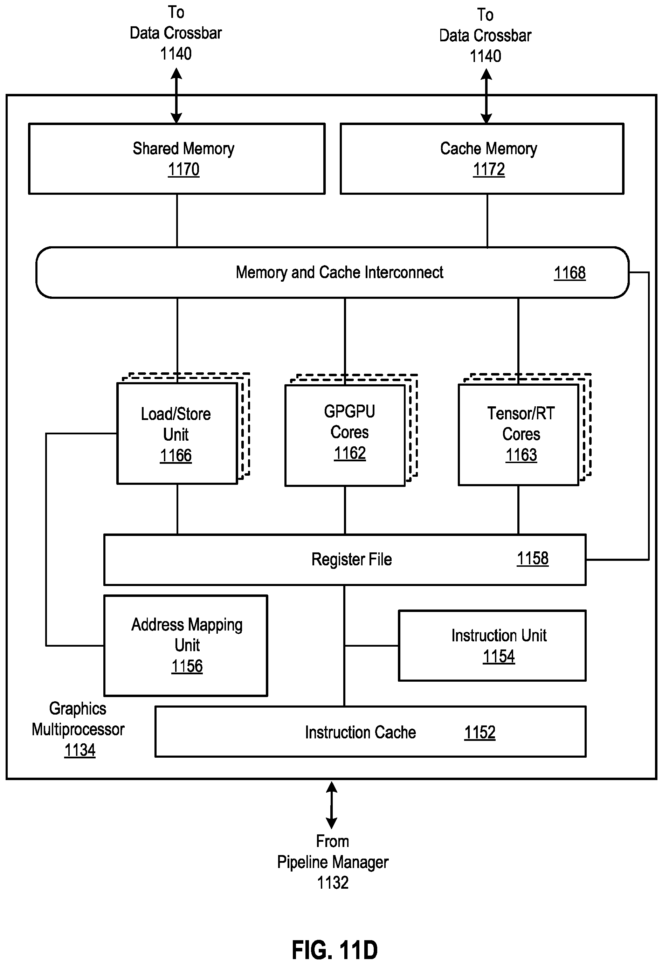

FIG. 11D shows an example of the graphics multiprocessor 1134 in which the graphics multiprocessor 1134 couples with the pipeline manager 1132 of the processing cluster 1114. The graphics multiprocessor 1134 has an execution pipeline including but not limited to an instruction cache 1152, an instruction unit 1154, an address mapping unit 1156, a register file 1158, one or more general purpose graphics processing unit (GPGPU) cores 1162, and one or more load/store units 1166. The GPGPU cores 1162 and load/store units 1166 are coupled with cache memory 1172 and shared memory 1170 via a memory and cache interconnect 1168. The graphics multiprocessor 1134 may additionally include tensor and/or ray-tracing cores 1163 that include hardware logic to accelerate matrix and/or ray-tracing operations.

The instruction cache 1152 may receive a stream of instructions to execute from the pipeline manager 1132. The instructions are cached in the instruction cache 1152 and dispatched for execution by the instruction unit 1154. The instruction unit 1154 can dispatch instructions as thread groups (e.g., warps), with each thread of the thread group assigned to a different execution unit within GPGPU core 1162. An instruction can access any of a local, shared, or global address space by specifying an address within a unified address space. The address mapping unit 1156 can be used to translate addresses in the unified address space into a distinct memory address that can be accessed by the load/store units 1166.

The register file 1158 provides a set of registers for the functional units of the graphics multiprocessor 1134. The register file 1158 provides temporary storage for operands connected to the data paths of the functional units (e.g., GPGPU cores 1162, load/store units 1166) of the graphics multiprocessor 1134. The register file 1158 may be divided between each of the functional units such that each functional unit is allocated a dedicated portion of the register file 1158. For example, the register file 1158 may be divided between the different warps being executed by the graphics multiprocessor 1134.

The GPGPU cores 1162 can each include floating point units (FPUs) and/or integer arithmetic logic units (ALUs) that are used to execute instructions of the graphics multiprocessor 1134. In some implementations, the GPGPU cores 1162 can include hardware logic that may otherwise reside within the tensor and/or ray-tracing cores 1163. The GPGPU cores 1162 can be similar in architecture or can differ in architecture. For example and in some examples, a first portion of the GPGPU cores 1162 include a single precision FPU and an integer ALU while a second portion of the GPGPU cores include a double precision FPU. Optionally, the FPUs can implement the IEEE 754-2008 standard for floating point arithmetic or enable variable precision floating point arithmetic. The graphics multiprocessor 1134 can additionally include one or more fixed function or special function units to perform specific functions such as copy rectangle or pixel blending operations. One or more of the GPGPU cores can also include fixed or special function logic.

The GPGPU cores 1162 may include SIMD logic capable of performing a single instruction on multiple sets of data. Optionally, GPGPU cores 1162 can physically execute SIMD4, SIMD8, and SIMD16 instructions and logically execute SIMD1, SIMD2, and SIMD32 instructions. The SIMD instructions for the GPGPU cores can be generated at compile time by a shader compiler or automatically generated when executing programs written and compiled for single program multiple data (SPMD) or SIMT architectures. Multiple threads of a program configured for the SIMT execution model can be executed via a single SIMD instruction. For example and in some examples, eight SIMT threads that perform the same or similar operations can be executed in parallel via a single SIMD8 logic unit.

The memory and cache interconnect 1168 is an interconnect network that connects each of the functional units of the graphics multiprocessor 1134 to the register file 1158 and to the shared memory 1170. For example, the memory and cache interconnect 1168 is a crossbar interconnect that allows the load/store unit 1166 to implement load and store operations between the shared memory 1170 and the register file 1158. The register file 1158 can operate at the same frequency as the GPGPU cores 1162, thus data transfer between the GPGPU cores 1162 and the register file 1158 is very low latency. The shared memory 1170 can be used to enable communication between threads that execute on the functional units within the graphics multiprocessor 1134. The cache memory 1172 can be used as a data cache for example, to cache texture data communicated between the functional units and the texture unit 1136. The shared memory 1170 can also be used as a program managed cached. The shared memory 1170 and the cache memory 1172 can couple with the data crossbar 1140 to enable communication with other components of the processing cluster. Threads executing on the GPGPU cores 1162 can programmatically store data within the shared memory in addition to the automatically cached data that is stored within the cache memory 1172.

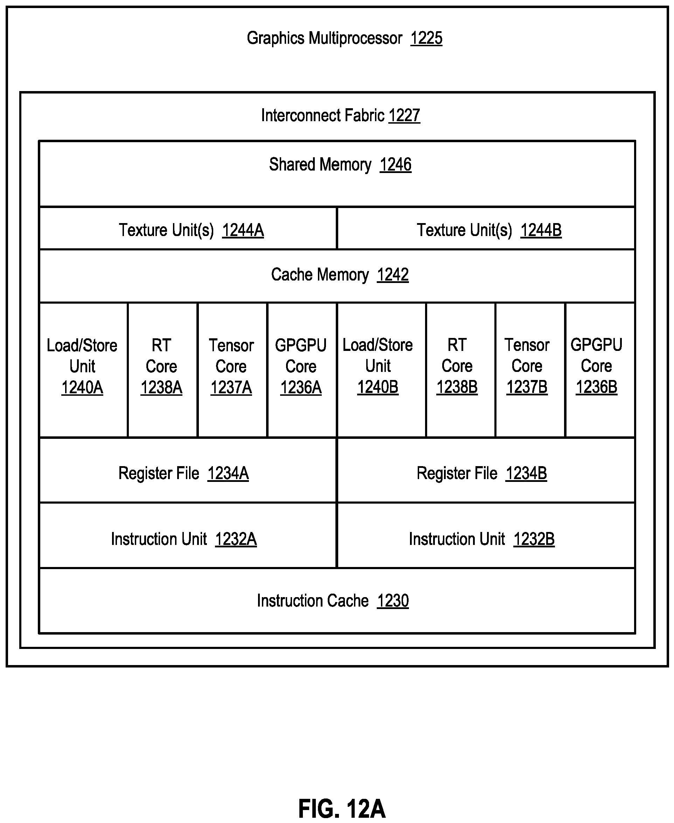

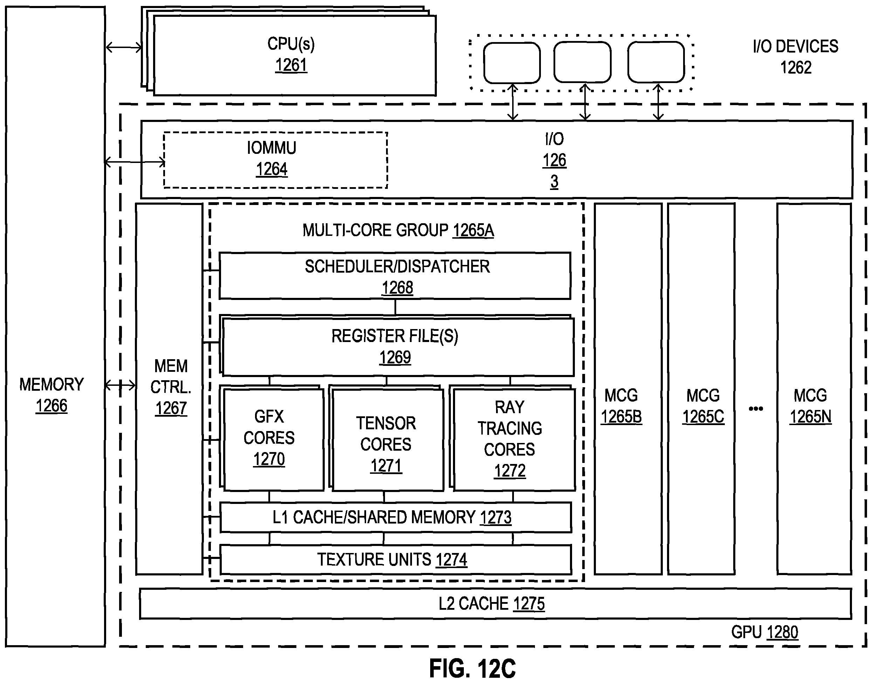

FIGS. 12A-12C illustrate additional graphics multiprocessors, according to examples. FIG. 12A-12B illustrate graphics multiprocessors 1225, 1250, which are related to the graphics multiprocessor 1134 of FIG. 11C and may be used in place of one of those. Therefore, the disclosure of any features in combination with the graphics multiprocessor 1134 herein also discloses a corresponding combination with the graphics multiprocessor(s) 1225, 1250, but is not limited to such. FIG. 12C illustrates a graphics processing unit (GPU) 1280 which includes dedicated sets of graphics processing resources arranged into multi-core groups 1265A-1265N, which correspond to the graphics multiprocessors 1225, 1250. The illustrated graphics multiprocessors 1225, 1250 and the multi-core groups 1265A-1265N can be streaming multiprocessors (SM) capable of simultaneous execution of a large number of execution threads.

The graphics multiprocessor 1225 of FIG. 12A includes multiple additional instances of execution resource units relative to the graphics multiprocessor 1134 of FIG. 11D. For example, the graphics multiprocessor 1225 can include multiple instances of the instruction unit 1232A-1232B, register file 1234A-1234B, and texture unit(s) 1244A-1244B. The graphics multiprocessor 1225 also includes multiple sets of graphics or compute execution units (e.g., GPGPU core 1236A-1236B, tensor core 1237A-1237B, ray-tracing core 1238A-1238B) and multiple sets of load/store units 1240A-1240B. The execution resource units have a common instruction cache 1230, texture and/or data cache memory 1242, and shared memory 1246.

The various components can communicate via an interconnect fabric 1227. The interconnect fabric 1227 may include one or more crossbar switches to enable communication between the various components of the graphics multiprocessor 1225. The interconnect fabric 1227 may be a separate, high-speed network fabric layer upon which each component of the graphics multiprocessor 1225 is stacked. The components of the graphics multiprocessor 1225 communicate with remote components via the interconnect fabric 1227. For example, the cores 1236A-1236B, 1237A-1237B, and 1238A-1238B can each communicate with shared memory 1246 via the interconnect fabric 1227. The interconnect fabric 1227 can arbitrate communication within the graphics multiprocessor 1225 to ensure a fair bandwidth allocation between components.

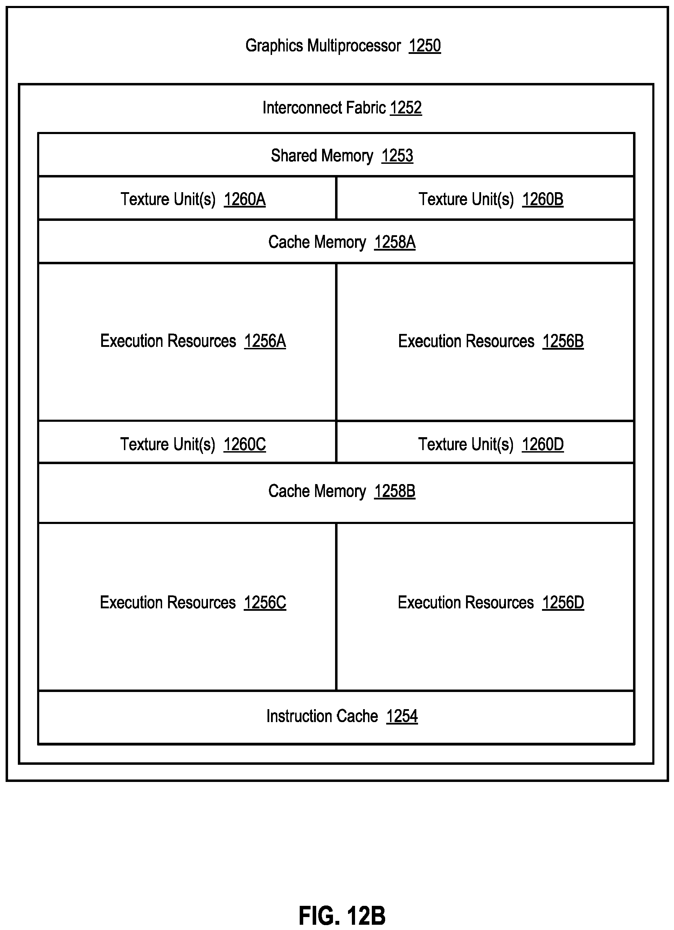

The graphics multiprocessor 1250 of FIG. 12B includes multiple sets of execution resources 1256A-1256D, where each set of execution resource includes multiple instruction units, register files, GPGPU cores, and load store units, as illustrated in FIG. 11D and FIG. 12A. The execution resources 1256A-1256D can work in concert with texture unit(s) 1260A-1260D for texture operations, while sharing an instruction cache 1254, and shared memory 1253. For example, the execution resources 1256A-1256D can share an instruction cache 1254 and shared memory 1253, as well as multiple instances of a texture and/or data cache memory 1258A-1258B. The various components can communicate via an interconnect fabric 1252 similar to the interconnect fabric 1227 of FIG. 12A.

Persons skilled in the art will understand that the architecture described in FIG. 1, 11A-11D, and 12A-12B are descriptive and not limiting as to the scope of the present examples. Thus, the techniques described herein may be implemented on any properly configured processing unit, including, without limitation, one or more mobile application processors, one or more desktop or server central processing units (CPUs) including multi-core CPUs, one or more parallel processing units, such as the parallel processing unit 1102 of FIG. 11A, as well as one or more graphics processors or special purpose processing units, without departure from the scope of the examples described herein.

The parallel processor or GPGPU as described herein may be communicatively coupled to host/processor cores to accelerate graphics operations, machine-learning operations, pattern analysis operations, and various general-purpose GPU (GPGPU) functions. The GPU may be communicatively coupled to the host processor/cores over a bus or other interconnect (e.g., a high-speed interconnect such as PCIe, NVLink, or other known protocols, standardized protocols, or proprietary protocols). In other examples, the GPU may be integrated on the same package or chip as the cores and communicatively coupled to the cores over an internal processor bus/interconnect (i.e., internal to the package or chip). Regardless of the manner in which the GPU is connected, the processor cores may allocate work to the GPU in the form of sequences of commands/instructions contained in a work descriptor. The GPU then uses dedicated circuitry/logic for efficiently processing these commands/instructions.

FIG. 12C illustrates a graphics processing unit (GPU) 1280 which includes dedicated sets of graphics processing resources arranged into multi-core groups 1265A-1265N. While the details of only a single multi-core group 1265A are provided, it will be appreciated that the other multi-core groups 1265B-1265N may be equipped with the same or similar sets of graphics processing resources. Details described with respect to the multi-core groups 1265A-1265N may also apply to any graphics multiprocessor 1134, 1225, 1250 described herein.

As illustrated, a multi-core group 1265A may include a set of graphics cores 1270, a set of tensor cores 1271, and a set of ray tracing cores 1272. A scheduler/dispatcher 1268 schedules and dispatches the graphics threads for execution on the various cores 1270, 1271, 1272. A set of register files 1269 store operand values used by the cores 1270, 1271, 1272 when executing the graphics threads. These may include, for example, integer registers for storing integer values, floating point registers for storing floating point values, vector registers for storing packed data elements (integer and/or floating-point data elements) and tile registers for storing tensor/matrix values. The tile registers may be implemented as combined sets of vector registers.

One or more combined level 1 (L1) caches and shared memory units 1273 store graphics data such as texture data, vertex data, pixel data, ray data, bounding volume data, etc., locally within each multi-core group 1265A. One or more texture units 1274 can also be used to perform texturing operations, such as texture mapping and sampling. A Level 2 (L2) cache 1275 shared by all or a subset of the multi-core groups 1265A-1265N stores graphics data and/or instructions for multiple concurrent graphics threads. As illustrated, the L2 cache 1275 may be shared across a plurality of multi-core groups 1265A-1265N. One or more memory controllers 1267 couple the GPU 1280 to a memory 1266 which may be a system memory (e.g., DRAM) and/or a dedicated graphics memory (e.g., GDDR6 memory).

Input/output (I/O) circuitry 1263 couples the GPU 1280 to one or more I/O devices 1262 such as digital signal processors (DSPs), network controllers, or user input devices. An on-chip interconnect may be used to couple the I/O devices 1262 to the GPU 1280 and memory 1266. One or more I/O memory management units (IOMMUs) 1264 of the I/O circuitry 1263 couple the I/O devices 1262 directly to the system memory 1266. Optionally, the IOMMU 1264 manages multiple sets of page tables to map virtual addresses to physical addresses in system memory 1266. The I/O devices 1262, CPU(s) 1261, and GPU(s) 1280 may then share the same virtual address space.

In one implementation of the IOMMU 1264, the IOMMU 1264 supports virtualization. In this case, it may manage a first set of page tables to map guest/graphics virtual addresses to guest/graphics physical addresses and a second set of page tables to map the guest/graphics physical addresses to system/host physical addresses (e.g., within system memory 1266). The base addresses of each of the first and second sets of page tables may be stored in control registers and swapped out on a context switch (e.g., so that the new context is provided with access to the relevant set of page tables). While not illustrated in FIG. 12C, each of the cores 1270, 1271, 1272 and/or multi-core groups 1265A-1265N may include translation lookaside buffers (TLBs) to cache guest virtual to guest physical translations, guest physical to host physical translations, and guest virtual to host physical translations.

The CPU(s) 1261, GPUs 1280, and I/O devices 1262 may be integrated on a single semiconductor chip and/or chip package. The illustrated memory 1266 may be integrated on the same chip or may be coupled to the memory controllers 1267 via an off-chip interface. In one implementation, the memory 1266 comprises GDDR6 memory which shares the same virtual address space as other physical system-level memories, although the underlying principles described herein are not limited to this specific implementation.

The tensor cores 1271 may include a plurality of execution units specifically designed to perform matrix operations, which are the fundamental compute operation used to perform deep learning operations. For example, simultaneous matrix multiplication operations may be used for neural network training and inferencing. The tensor cores 1271 may perform matrix processing using a variety of operand precisions including single precision floating-point (e.g., 32 bits), half-precision floating point (e.g., 16 bits), integer words (16 bits), bytes (8 bits), and half-bytes (4 bits). For example, a neural network implementation extracts features of each rendered scene, potentially combining details from multiple frames, to construct a high-quality final image.

In deep learning implementations, parallel matrix multiplication work may be scheduled for execution on the tensor cores 1271. The training of neural networks, in particular, requires a significant number of matrix dot product operations. In order to process an inner-product formulation of an N x N x N matrix multiply, the tensor cores 1271 may include at least N dot-product processing elements. Before the matrix multiply begins, one entire matrix is loaded into tile registers and at least one column of a second matrix is loaded each cycle for N cycles. Each cycle, there are N dot products that are processed.

Matrix elements may be stored at different precisions depending on the particular implementation, including 16-bit words, 8-bit bytes (e.g., INT8) and 4-bit half-bytes (e.g., INT4). Different precision modes may be specified for the tensor cores 1271 to ensure that the most efficient precision is used for different workloads (e.g., such as inferencing workloads which can tolerate quantization to bytes and half-bytes). Supported formats additionally include 64-bit floating point (FP64) and non-IEEE floating point formats such as the bfloat16 format (e.g., Brain floating point), a 16-bit floating point format with one sign bit, eight exponent bits, and eight significand bits, of which seven are explicitly stored. One example includes support for a reduced precision tensor-float (TF32) mode, which performs computations using the range of FP32 (8-bits) and the precision of FP16 (10-bits). Reduced precision TF32 operations can be performed on FP32 inputs and produce FP32 outputs at higher performance relative to FP32 and increased precision relative to FP16. In some examples, one or more 8-bit floating point formats (FP8) are supported.

In some examples the tensor cores 1271 support a sparse mode of operation for matrices in which the vast majority of values are zero. The tensor cores 1271 include support for sparse input matrices that are encoded in a sparse matrix representation (e.g., coordinate list encoding (COO), compressed sparse row (CSR), compress sparse column (SC), etc.). The tensor cores 1271 also include support for compressed sparse matrix representations in the event that the sparse matrix representation may be further compressed. Compressed, encoded, and/or compressed and encoded matrix data, along with associated compression and/or encoding metadata, can be read by the tensor cores 1271 and the non-zero values can be extracted. For example, for a given input matrix A, a non-zero value can be loaded from the compressed and/or encoded representation of at least a portion of matrix A. Based on the location in matrix A for the non-zero value, which may be determined from index or coordinate metadata associated with the non-zero value, a corresponding value in input matrix B may be loaded. Depending on the operation to be performed (e.g., multiply), the load of the value from input matrix B may be bypassed if the corresponding value is a zero value. In some examples, the pairings of values for certain operations, such as multiply operations, may be pre-scanned by scheduler logic and only operations between non-zero inputs are scheduled. Depending on the dimensions of matrix A and matrix B and the operation to be performed, output matrix C may be dense or sparse. Where output matrix C is sparse and depending on the configuration of the tensor cores 1271, output matrix C may be output in a compressed format, a sparse encoding, or a compressed sparse encoding.

The ray tracing cores 1272 may accelerate ray tracing operations for both real-time ray tracing and non-real-time ray tracing implementations. In particular, the ray tracing cores 1272 may include ray traversal/intersection circuitry for performing ray traversal using bounding volume hierarchies (BVHs) and identifying intersections between rays and primitives enclosed within the BVH volumes. The ray tracing cores 1272 may also include circuitry for performing depth testing and culling (e.g., using a Z buffer or similar arrangement). In one implementation, the ray tracing cores 1272 perform traversal and intersection operations in concert with the image denoising techniques described herein, at least a portion of which may be executed on the tensor cores 1271. For example, the tensor cores 1271 may implement a deep learning neural network to perform denoising of frames generated by the ray tracing cores 1272. However, the CPU(s) 1261, graphics cores 1270, and/or ray tracing cores 1272 may also implement all or a portion of the denoising and/or deep learning algorithms.

In addition, as described above, a distributed approach to denoising may be employed in which the GPU 1280 is in a computing device coupled to other computing devices over a network or high-speed interconnect. In this distributed approach, the interconnected computing devices may share neural network learning/training data to improve the speed with which the overall system learns to perform denoising for different types of image frames and/or different graphics applications.

The ray tracing cores 1272 may process all BVH traversal and/or ray-primitive intersections, saving the graphics cores 1270 from being overloaded with thousands of instructions per ray. For example, each ray tracing core 1272 includes a first set of specialized circuitry for performing bounding box tests (e.g., for traversal operations) and/or a second set of specialized circuitry for performing the ray-triangle intersection tests (e.g., intersecting rays which have been traversed). Thus, for example, the multi-core group 1265A can simply launch a ray probe, and the ray tracing cores 1272 independently perform ray traversal and intersection and return hit data (e.g., a hit, no hit, multiple hits, etc.) to the thread context. The other cores 1270, 1271 are freed to perform other graphics or compute work while the ray tracing cores 1272 perform the traversal and intersection operations.

Optionally, each ray tracing core 1272 may include a traversal unit to perform BVH testing operations and/or an intersection unit which performs ray-primitive intersection tests. The intersection unit generates a "hit", "no hit", or "multiple hit" response, which it provides to the appropriate thread. During the traversal and intersection operations, the execution resources of the other cores (e.g., graphics cores 1270 and tensor cores 1271) are freed to perform other forms of graphics work.

In some examples described below, a hybrid rasterization/ray tracing approach is used in which work is distributed between the graphics cores 1270 and ray tracing cores 1272.

The ray tracing cores 1272 (and/or other cores 1270, 1271) may include hardware support for a ray tracing instruction set such as Microsoft's DirectX Ray Tracing (DXR) which includes a DispatchRays command, as well as ray-generation, closest-hit, any-hit, and miss shaders, which enable the assignment of unique sets of shaders and textures for each object. Another ray tracing platform which may be supported by the ray tracing cores 1272, graphics cores 1270 and tensor cores 1271 is Vulkan API (e.g., Vulkan version 1.1.85 and later). Note, however, that the underlying principles described herein are not limited to any particular ray tracing ISA.

In general, the various cores 1272, 1271, 1270 may support a ray tracing instruction set that includes instructions/functions for one or more of ray generation, closest hit, any hit, ray-primitive intersection, per-primitive and hierarchical bounding box construction, miss, visit, and exceptions. More specifically, some examples includes ray tracing instructions to perform one or more of the following functions:
- Ray Generation - Ray generation instructions may be executed for each pixel, sample, or other user-defined work assignment.
- Closest Hit - A closest hit instruction may be executed to locate the closest intersection point of a ray with primitives within a scene.
- Any Hit - An any hit instruction identifies multiple intersections between a ray and primitives within a scene, potentially to identify a new closest intersection point.
- Intersection - An intersection instruction performs a ray-primitive intersection test and outputs a result.
- Per-primitive Bounding box Construction -This instruction builds a bounding box around a given primitive or group of primitives (e.g., when building a new BVH or other acceleration data structure).
- Miss - Indicates that a ray misses all geometry within a scene, or specified region of a scene.
- Visit - Indicates the child volumes a ray will traverse.
- Exceptions - Includes various types of exception handlers (e.g., invoked for various error conditions).

In some examples the ray tracing cores 1272 may be adapted to accelerate general-purpose compute operations that can be accelerated using computational techniques that are analogous to ray intersection tests. A compute framework can be provided that enables shader programs to be compiled into low level instructions and/or primitives that perform general-purpose compute operations via the ray tracing cores. Exemplary computational problems that can benefit from compute operations performed on the ray tracing cores 1272 include computations involving beam, wave, ray, or particle propagation within a coordinate space. Interactions associated with that propagation can be computed relative to a geometry or mesh within the coordinate space. For example, computations associated with electromagnetic signal propagation through an environment can be accelerated via the use of instructions or primitives that are executed via the ray tracing cores. Diffraction and reflection of the signals by objects in the environment can be computed as direct ray-tracing analogies.

Ray tracing cores 1272 can also be used to perform computations that are not directly analogous to ray tracing. For example, mesh projection, mesh refinement, and volume sampling computations can be accelerated using the ray tracing cores 1272. Generic coordinate space calculations, such as nearest neighbor calculations can also be performed. For example, the set of points near a given point can be discovered by defining a bounding box in the coordinate space around the point. BVH and ray probe logic within the ray tracing cores 1272 can then be used to determine the set of point intersections within the bounding box. The intersections constitute the origin point and the nearest neighbors to that origin point. Computations that are performed using the ray tracing cores 1272 can be performed in parallel with computations performed on the graphics cores 1272 and tensor cores 1271. A shader compiler can be configured to compile a compute shader or other general-purpose graphics processing program into low level primitives that can be parallelized across the graphics cores 1270, tensor cores 1271, and ray tracing cores 1272.

Building larger and larger silicon dies is challenging for a variety of reasons. As silicon dies become larger, manufacturing yields become smaller and process technology requirements for different components may diverge. On the other hand, in order to have a high-performance system, key components should be interconnected by high speed, high bandwidth, low latency interfaces. These contradicting needs pose a challenge to high performance chip development.

Embodiments described herein provide techniques to disaggregate an architecture of a system on a chip integrated circuit into multiple distinct chiplets that can be packaged onto a common chassis. In some examples, a graphics processing unit or parallel processor is composed from diverse silicon chiplets that are separately manufactured. A chiplet is an at least partially packaged integrated circuit that includes distinct units of logic that can be assembled with other chiplets into a larger package. A diverse set of chiplets with different IP core logic can be assembled into a single device. Additionally the chiplets can be integrated into a base die or base chiplet using active interposer technology. The concepts described herein enable the interconnection and communication between the different forms of IP within the GPU. The development of IPs on different process may be mixed. This avoids the complexity of converging multiple IPs, especially on a large SoC with several flavors IPs, to the same process.

Enabling the use of multiple process technologies improves the time to market and provides a cost-effective way to create multiple product SKUs. For customers, this means getting products that are more tailored to their requirements in a cost effective and timely manner. Additionally, the disaggregated IPs are more amenable to being power gated independently, components that are not in use on a given workload can be powered off, reducing overall power consumption.

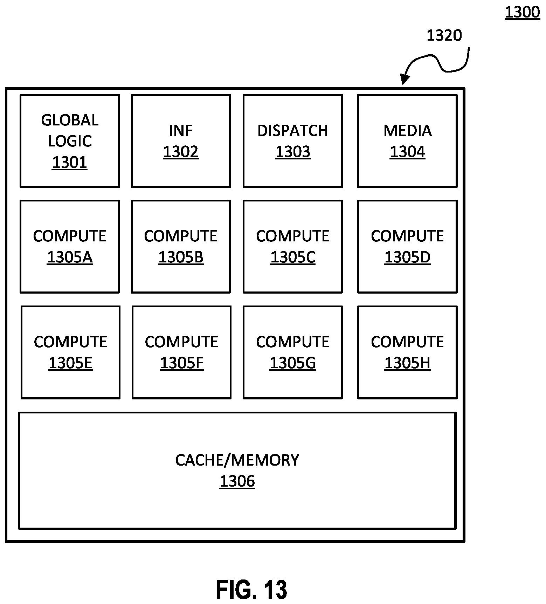

FIG. 13 shows a parallel compute system 1300, according to some examples. In some examples the parallel compute system 1300 includes a parallel processor 1320, which can be a graphics processor or compute accelerator as described herein. The parallel processor 1320 includes a global logic unit 1301, an interface 1302, a thread dispatcher 1303, a media unit 1304, a set of compute units 1305A-1305H, and a cache/memory units 1306. The global logic unit 1301, in some examples, includes global functionality for the parallel processor 1320, including device configuration registers, global schedulers, power management logic, and the like. The interface 1302 can include a front-end interface for the parallel processor 1320. The thread dispatcher 1303 can receive workloads from the interface 1302 and dispatch threads for the workload to the compute units 1305A-1305H. If the workload includes any media operations, at least a portion of those operations can be performed by the media unit 1304. The media unit can also offload some operations to the compute units 1305A-1305H. The cache/memory units 1306 can include cache memory (e.g., L3 cache) and local memory (e.g., HBM, GDDR) for the parallel processor 1320.

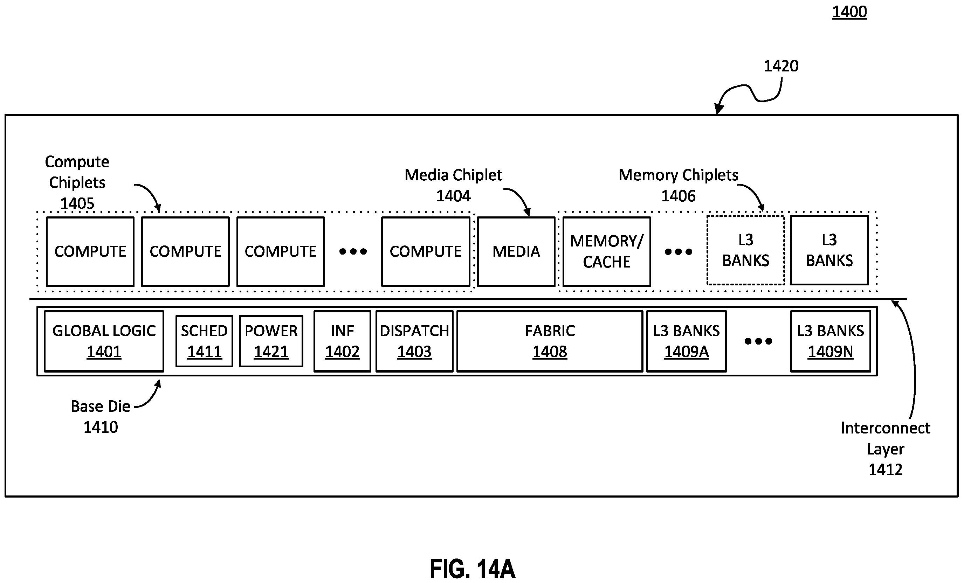

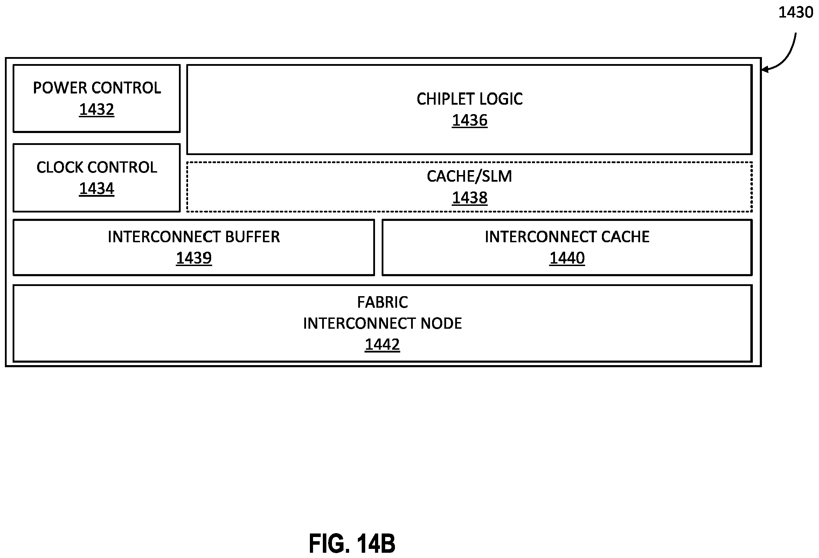

FIGS. 14A-14B illustrate a hybrid logical/physical view of a disaggregated parallel processor, according to examples described herein. FIG. 14A illustrates a disaggregated parallel compute system 1400. FIG. 14B illustrates a chiplet 1430 of the disaggregated parallel compute system 1400.

As shown in FIG. 14A, a disaggregated compute system 1400 can include a parallel processor 1420 in which the various components of the parallel processor SOC are distributed across multiple chiplets. Each chiplet can be a distinct IP core that is independently designed and configured to communicate with other chiplets via one or more common interfaces. The chiplets include but are not limited to compute chiplets 1405, a media chiplet 1404, and memory chiplets 1406. Each chiplet can be separately manufactured using different process technologies. For example, compute chiplets 1405 may be manufactured using the smallest or most advanced process technology available at the time of fabrication, while memory chiplets 1406 or other chiplets (e.g., I/O, networking, etc.) may be manufactured using a larger or less advanced process technologies.

The various chiplets can be bonded to a base die 1410 and configured to communicate with each other and logic within the base die 1410 via an interconnect layer 1412. In some examples, the base die 1410 can include global logic 1401, which can include scheduler 1411 and power management 1421 logic units, an interface 1402, a dispatch unit 1403, and an interconnect fabric module 1408 coupled with or integrated with one or more L3 cache banks 1409A-1409N. The interconnect fabric 1408 can be an inter-chiplet fabric that is integrated into the base die 1410. Logic chiplets can use the fabric 1408 to relay messages between the various chiplets. Additionally, L3 cache banks 1409A-1409N in the base die and/or L3 cache banks within the memory chiplets 1406 can cache data read from and transmitted to DRAM chiplets within the memory chiplets 1406 and to system memory of a host.

In some examples the global logic 1401 is a microcontroller that can execute firmware to perform scheduler 1411 and power management 1421 functionality for the parallel processor 1420. The microcontroller that executes the global logic can be tailored for the target use case of the parallel processor 1420. The scheduler 1411 can perform global scheduling operations for the parallel processor 1420. The power management 1421 functionality can be used to enable or disable individual chiplets within the parallel processor when those chiplets are not in use.

The various chiplets of the parallel processor 1420 can be designed to perform specific functionality that, in existing designs, would be integrated into a single die. A set of compute chiplets 1405 can include clusters of compute units (e.g., execution units, streaming multiprocessors, etc.) that include programmable logic to execute compute or graphics shader instructions. A media chiplet 1404 can include hardware logic to accelerate media encode and decode operations. Memory chiplets 1406 can include volatile memory (e.g., DRAM) and one or more SRAM cache memory banks (e.g., L3 banks).

As shown in FIG. 14B, each chiplet 1430 can include common components and application specific components. Chiplet logic 1436 within the chiplet 1430 can include the specific components of the chiplet, such as an array of streaming multiprocessors, compute units, or execution units described herein. The chiplet logic 1436 can couple with an optional cache or shared local memory 1438 or can include a cache or shared local memory within the chiplet logic 1436. The chiplet 1430 can include a fabric interconnect node 1442 that receives commands via the inter-chiplet fabric. Commands and data received via the fabric interconnect node 1442 can be stored temporarily within an interconnect buffer 1439. Data transmitted to and received from the fabric interconnect node 1442 can be stored in an interconnect cache 1440. Power control 1432 and clock control 1434 logic can also be included within the chiplet. The power control 1432 and clock control 1434 logic can receive configuration commands via the fabric can configure dynamic voltage and frequency scaling for the chiplet 1430. In some examples, each chiplet can have an independent clock domain and power domain and can be clock gated and power gated independently of other chiplets.

At least a portion of the components within the illustrated chiplet 1430 can also be included within logic embedded within the base die 1410 of FIG. 14A. For example, logic within the base die that communicates with the fabric can include a version of the fabric interconnect node 1442. Base die logic that can be independently clock or power gated can include a version of the power control 1432 and/or clock control 1434 logic.

Thus, while various examples described herein use the term SOC to describe a device or system having a processor and associated circuitry (e.g., Input/Output ("I/O") circuitry, power delivery circuitry, memory circuitry, etc.) integrated monolithically into a single Integrated Circuit ("IC") die, or chip, the present disclosure is not limited in that respect. For example, in various examples of the present disclosure, a device or system can have one or more processors (e.g., one or more processor cores) and associated circuitry (e.g., Input/Output ("I/O") circuitry, power delivery circuitry, etc.) arranged in a disaggregated collection of discrete dies, tiles and/or chiplets (e.g., one or more discrete processor core die arranged adjacent to one or more other die such as memory die, I/O die, etc.). In such disaggregated devices and systems the various dies, tiles and/or chiplets can be physically and electrically coupled together by a package structure including, for example, various packaging substrates, interposers, active interposers, photonic interposers, interconnect bridges and the like. The disaggregated collection of discrete dies, tiles, and/or chiplets can also be part of a System-on-Package ("SoP")."

### Example Core Architectures - In-order and out-of-order core block diagram.

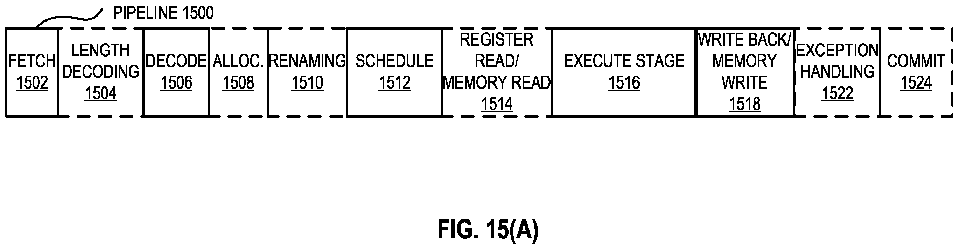

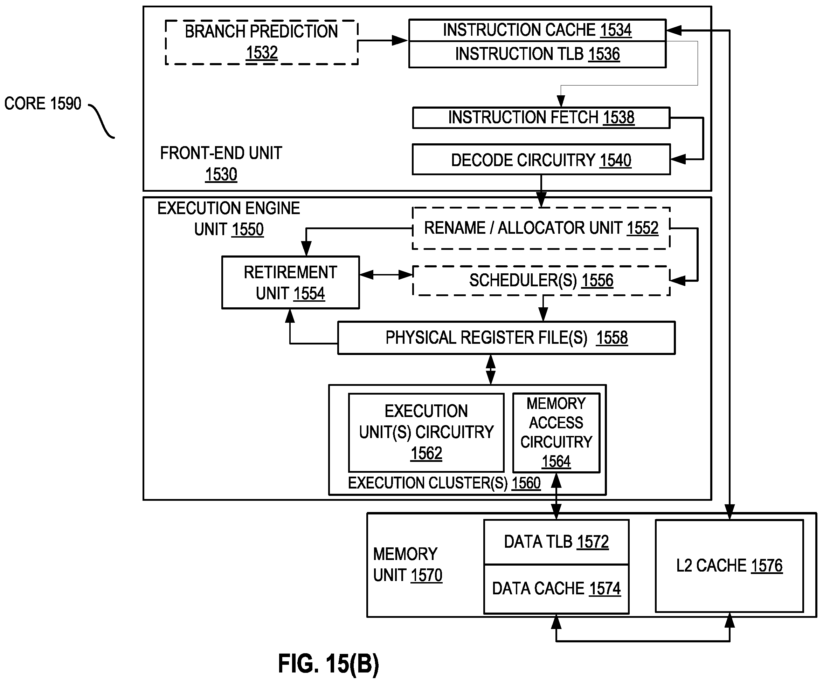

FIG. 15(A) is a block diagram illustrating both an example in-order pipeline and an example register renaming, out-of-order issue/execution pipeline according to examples. FIG. 15(B) is a block diagram illustrating both an example in-order architecture core and an example register renaming, out-of-order issue/execution architecture core to be included in a processor according to examples. The solid lined boxes in FIGS. 15(A)-(B) illustrate the in-order pipeline and in-order core, while the optional addition of the dashed lined boxes illustrates the register renaming, out-of-order issue/execution pipeline and core. Given that the in-order aspect is a subset of the out-of-order aspect, the out-of-order aspect will be described.

In FIG. 15(A), a processor pipeline 1500 includes a fetch stage 1502, an optional length decoding stage 1504, a decode stage 1506, an optional allocation (Alloc) stage 1508, an optional renaming stage 1510, a schedule (also known as a dispatch or issue) stage 1512, an optional register read/memory read stage 1514, an execute stage 1516, a write back/memory write stage 1518, an optional exception handling stage 1522, and an optional commit stage 1524. One or more operations can be performed in each of these processor pipeline stages. For example, during the fetch stage 1502, one or more instructions are fetched from instruction memory, and during the decode stage 1506, the one or more fetched instructions may be decoded, addresses (e.g., load store unit (LSU) addresses) using forwarded register ports may be generated, and branch forwarding (e.g., immediate offset or a link register (LR)) may be performed. In some examples, the decode stage 1506 and the register read/memory read stage 1514 may be combined into one pipeline stage. In some examples, during the execute stage 1516, the decoded instructions may be executed, LSU address/data pipelining to an Advanced Microcontroller Bus (AMB) interface may be performed, multiply and add operations may be performed, arithmetic operations with branch results may be performed, etc.

By way of example, the example register renaming, out-of-order issue/execution architecture core of FIG. 15(B) may implement the pipeline 1500 as follows: 1) the instruction fetch circuitry 1538 performs the fetch and length decoding stages 1502 and 1504; 2) the decode circuitry 1540 performs the decode stage 1506; 3) the rename/allocator unit circuitry 1552 performs the allocation stage 1508 and renaming stage 1510; 4) the scheduler(s) circuitry 1556 performs the schedule stage 1512; 5) the physical register file(s) circuitry 1558 and the memory unit circuitry 1570 perform the register read/memory read stage 1514; the execution cluster(s) 1560 perform the execute stage 1516; 6) the memory unit circuitry 1570 and the physical register file(s) circuitry 1558 perform the write back/memory write stage 1518; 7) various circuitry may be involved in the exception handling stage 1522; and 8) the retirement unit circuitry 1554 and the physical register file(s) circuitry 1558 perform the commit stage 1524.

FIG. 15(B) shows a processor core 1590 including front-end unit circuitry 1530 coupled to execution engine unit circuitry 1550, and both are coupled to memory unit circuitry 1570. The core 1590 may be a reduced instruction set architecture computing (RISC) core, a complex instruction set architecture computing (CISC) core, a very long instruction word (VLIW) core, or a hybrid or alternative core type. As yet another option, the core 1590 may be a special-purpose core, such as, for example, a network or communication core, compression engine, coprocessor core, general purpose computing graphics processing unit (GPGPU) core, graphics core, or the like.

The front-end unit circuitry 1530 may include branch prediction circuitry 1532 coupled to instruction cache circuitry 1534, which is coupled to an instruction translation lookaside buffer (TLB) 1536, which is coupled to instruction fetch circuitry 1538, which is coupled to decode circuitry 1540. In some examples, the instruction cache circuitry 1534 is included in the memory unit circuitry 1570 rather than the front-end circuitry 1530. The decode circuitry 1540 (or decoder) may decode instructions, and generate as an output one or more micro-operations, micro-code entry points, microinstructions, other instructions, or other control signals, which are decoded from, or which otherwise reflect, or are derived from, the original instructions. The decode circuitry 1540 may further include address generation unit (AGU, not shown) circuitry. In some examples, the AGU generates an LSU address using forwarded register ports, and may further perform branch forwarding (e.g., immediate offset branch forwarding, LR register branch forwarding, etc.). The decode circuitry 1540 may be implemented using various different mechanisms. Examples of suitable mechanisms include, but are not limited to, look-up tables, hardware implementations, programmable logic arrays (PLAs), microcode read only memories (ROMs), etc. In some examples, the core 1590 includes a microcode ROM (not shown) or other medium that stores microcode for certain macroinstructions (e.g., in decode circuitry 1540 or otherwise within the front-end circuitry 1530). In some examples, the decode circuitry 1540 includes a micro-operation (micro-op) or operation cache (not shown) to hold/cache decoded operations, micro-tags, or micro-operations generated during the decode or other stages of the processor pipeline 1500. The decode circuitry 1540 may be coupled to rename/allocator unit circuitry 1552 in the execution engine circuitry 1550.

The execution engine circuitry 1550 includes the rename/allocator unit circuitry 1552 coupled to retirement unit circuitry 1554 and a set of one or more scheduler(s) circuitry 1556. The scheduler(s) circuitry 1556 represents any number of different schedulers, including reservations stations, central instruction window, etc. In some examples, the scheduler(s) circuitry 1556 can include arithmetic logic unit (ALU) scheduler/scheduling circuitry, ALU queues, address generation unit (AGU) scheduler/scheduling circuitry, AGU queues, etc. The scheduler(s) circuitry 1556 is coupled to the physical register file(s) circuitry 1558. Each of the physical register file(s) circuitry 1558 represents one or more physical register files, different ones of which store one or more different data types, such as scalar integer, scalar floating-point, packed integer, packed floating-point, vector integer, vector floating-point, status (e.g., an instruction pointer that is the address of the next instruction to be executed), etc. In some examples, the physical register file(s) circuitry 1558 includes vector registers unit circuitry, writemask registers unit circuitry, and scalar register unit circuitry. These register units may provide architectural vector registers, vector mask registers, general-purpose registers, etc. The physical register file(s) circuitry 1558 is coupled to the retirement unit circuitry 1554 (also known as a retire queue or a retirement queue) to illustrate various ways in which register renaming and out-of-order execution may be implemented (e.g., using a reorder buffer(s) (ROB(s)) and a retirement register file(s); using a future file(s), a history buffer(s), and a retirement register file(s); using a register maps and a pool of registers; etc.). The retirement unit circuitry 1554 and the physical register file(s) circuitry 1558 are coupled to the execution cluster(s) 1560. The execution cluster(s) 1560 includes a set of one or more execution unit(s) circuitry 1562 and a set of one or more memory access circuitry 1564. The execution unit(s) circuitry 1562 may perform various arithmetic, logic, floating-point or other types of operations (e.g., shifts, addition, subtraction, multiplication) and on various types of data (e.g., scalar integer, scalar floating-point, packed integer, packed floating-point, vector integer, vector floating-point). While some examples may include a number of execution units or execution unit circuitry dedicated to specific functions or sets of functions, other examples may include only one execution unit circuitry or multiple execution units/execution unit circuitry that all perform all functions. The scheduler(s) circuitry 1556, physical register file(s) circuitry 1558, and execution cluster(s) 1560 are shown as being possibly plural because certain examples create separate pipelines for certain types of data/operations (e.g., a scalar integer pipeline, a scalar floating-point/packed integer/packed floating-point/vector integer/vector floating-point pipeline, and/or a memory access pipeline that each have their own scheduler circuitry, physical register file(s) circuitry, and/or execution cluster - and in the case of a separate memory access pipeline, certain examples are implemented in which only the execution cluster of this pipeline has the memory access unit(s) circuitry 1564). It should also be understood that where separate pipelines are used, one or more of these pipelines may be out-of-order issue/execution and the rest in-order.

In some examples, the execution engine unit circuitry 1550 may perform load store unit (LSU) address/data pipelining to an Advanced Microcontroller Bus (AMB) interface (not shown), and address phase and writeback, data phase load, store, and branches.

The set of memory access circuitry 1564 is coupled to the memory unit circuitry 1570, which includes data TLB circuitry 1572 coupled to data cache circuitry 1574 coupled to level 2 (L2) cache circuitry 1576. In some examples, the memory access circuitry 1564 may include load unit circuitry, store address unit circuitry, and store data unit circuitry, each of which is coupled to the data TLB circuitry 1572 in the memory unit circuitry 1570. The instruction cache circuitry 1534 is further coupled to the level 2 (L2) cache circuitry 1576 in the memory unit circuitry 1570. In some examples, the instruction cache 1534 and the data cache 1574 are combined into a single instruction and data cache (not shown) in L2 cache circuitry 1576, level 3 (L3) cache circuitry (not shown), and/or main memory. The L2 cache circuitry 1576 is coupled to one or more other levels of cache and eventually to a main memory.

The core 1590 may support one or more instructions sets (e.g., the x86 instruction set architecture (optionally with some extensions that have been added with newer versions); the MIPS instruction set architecture; the ARM instruction set architecture (optionally with optional additional extensions such as NEON)), including the instruction(s) described herein. In some examples, the core 1590 includes logic to support a packed data instruction set architecture extension (e.g., AVX1, AVX2), thereby allowing the operations used by many multimedia applications to be performed using packed data.

### Example Execution Unit(s) Circuitry.

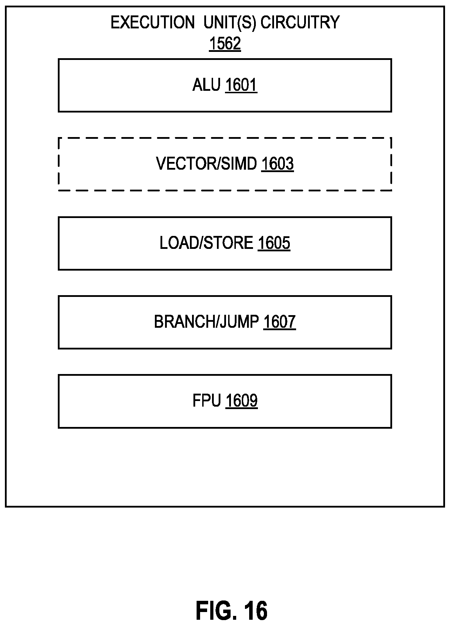

FIG. 16 illustrates examples of execution unit(s) circuitry, such as execution unit(s) circuitry 1562 of FIG. 15(B). As illustrated, execution unit(s) circuity 1562 may include one or more ALU circuits 1601, optional vector/single instruction multiple data (SIMD) circuits 1603, load/store circuits 1605, branch/jump circuits 1607, and/or Floating-point unit (FPU) circuits 1609. ALU circuits 1601 perform integer arithmetic and/or Boolean operations. Vector/SIMD circuits 1603 perform vector/SIMD operations on packed data (such as SIMD/vector registers). Load/store circuits 1605 execute load and store instructions to load data from memory into registers or store from registers to memory. Load/store circuits 1605 may also generate addresses. Branch/jump circuits 1607 cause a branch or jump to a memory address depending on the instruction. FPU circuits 1609 perform floating-point arithmetic. The width of the execution unit(s) circuitry 1562 varies depending upon the example and can range from 16-bit to 1,024-bit, for example. In some examples, two or more smaller execution units are logically combined to form a larger execution unit (e.g., two 128-bit execution units are logically combined to form a 256-bit execution unit).

### Example Register Architecture.

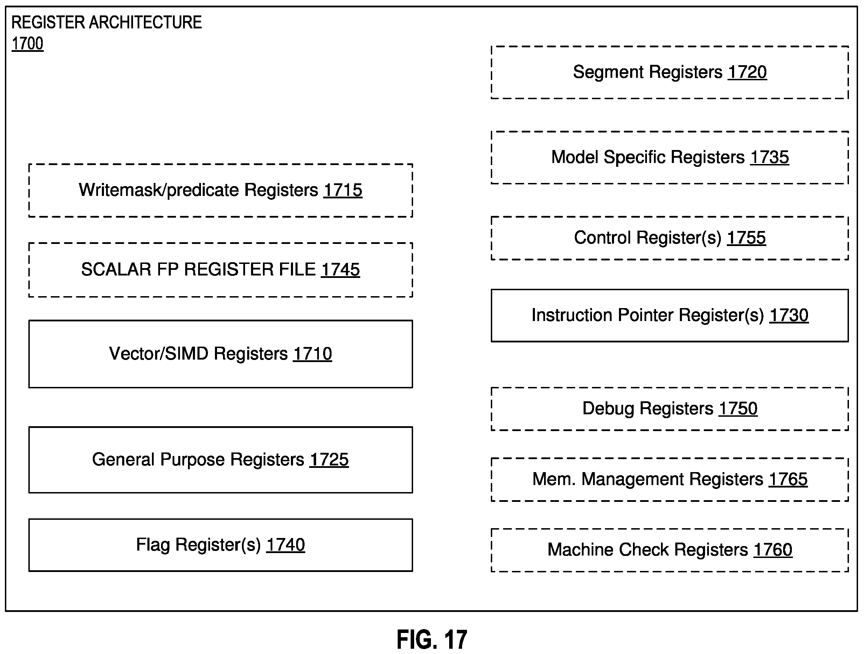

FIG. 17 is a block diagram of a register architecture 1700 according to some examples. As illustrated, the register architecture 1700 includes vector/SIMD registers 1710 that vary from 128-bit to 1,024 bits width. In some examples, the vector/SIMD registers 1710 are physically 512-bits and, depending upon the mapping, only some of the lower bits are used. For example, in some examples, the vector/SIMD registers 1710 are ZMM registers which are 512 bits: the lower 256 bits are used for YMM registers and the lower 128 bits are used for XMM registers. As such, there is an overlay of registers. In some examples, a vector length field selects between a maximum length and one or more other shorter lengths, where each such shorter length is half the length of the preceding length. Scalar operations are operations performed on the lowest order data element position in a ZMM/YMM/XMM register; the higher order data element positions are either left the same as they were prior to the instruction or zeroed depending on the example.

In some examples, the register architecture 1700 includes writemask/predicate registers 1715. For example, in some examples, there are 8 writemask/predicate registers (sometimes called k0 through k7) that are each 16-bit, 32-bit, 64-bit, or 128-bit in size. Writemask/predicate registers 1715 may allow for merging (e.g., allowing any set of elements in the destination to be protected from updates during the execution of any operation) and/or zeroing (e.g., zeroing vector masks allow any set of elements in the destination to be zeroed during the execution of any operation). In some examples, each data element position in a given writemask/predicate register 1715 corresponds to a data element position of the destination. In other examples, the writemask/predicate registers 1715 are scalable and consists of a set number of enable bits for a given vector element (e.g., 8 enable bits per 64-bit vector element).

The register architecture 1700 includes a plurality of general-purpose registers 1725. These registers may be 16-bit, 32-bit, 64-bit, etc. and can be used for scalar operations. In some examples, these registers are referenced by the names RAX, RBX, RCX, RDX, RBP, RSI, RDI, RSP, and R8 through R15.

In some examples, the register architecture 1700 includes scalar floating-point (FP) register file 1745 which is used for scalar floating-point operations on 32/64/80-bit floating-point data using the x87 instruction set architecture extension or as MMX registers to perform operations on 64-bit packed integer data, as well as to hold operands for some operations performed between the MMX and XMM registers.

One or more flag registers 1740 (e.g., EFLAGS, RFLAGS, etc.) store status and control information for arithmetic, compare, and system operations. For example, the one or more flag registers 1740 may store condition code information such as carry, parity, auxiliary carry, zero, sign, and overflow. In some examples, the one or more flag registers 1740 are called program status and control registers.

Segment registers 1720 contain segment points for use in accessing memory. In some examples, these registers are referenced by the names CS, DS, SS, ES, FS, and GS.

Model specific registers or machine specific registers (MSRs) 1735 control and report on processor performance. Most MSRs 1735 handle system-related functions and are not accessible to an application program. For example, MSRs may provide control for one or more of: performance-monitoring counters, debug extensions, memory type range registers, thermal and power management, instruction-specific support, and/or processor feature/mode support. Machine check registers 1760 consist of control, status, and error reporting MSRs that are used to detect and report on hardware errors. Control register(s) 1755 (e.g., CR0-CR4) determine the operating mode of a processor (e.g., processor 870, 880, 838, 815, and/or 900) and the characteristics of a currently executing task. In some examples, MSRs 1735 are a subset of control registers 1755.

One or more instruction pointer register(s) 1730 store an instruction pointer value. Debug registers 1750 control and allow for the monitoring of a processor or core's debugging operations.

Memory (mem) management registers 1765 specify the locations of data structures used in protected mode memory management. These registers may include a global descriptor table register (GDTR), interrupt descriptor table register (IDTR), task register, and a local descriptor table register (LDTR) register.

Alternative examples may use wider or narrower registers. Additionally, alternative examples may use more, less, or different register files and registers. The register architecture 1700 may, for example, be used in register file / memory 'ISAB08, or physical register file(s) circuitry 1558.

### Instruction Set Architectures.

An instruction set architecture (ISA) may include one or more instruction formats. A given instruction format may define various fields (e.g., number of bits, location of bits) to specify, among other things, the operation to be performed (e.g., opcode) and the operand(s) on which that operation is to be performed and/or other data field(s) (e.g., mask). Some instruction formats are further broken down through the definition of instruction templates (or sub-formats). For example, the instruction templates of a given instruction format may be defined to have different subsets of the instruction format's fields (the included fields are typically in the same order, but at least some have different bit positions because there are less fields included) and/or defined to have a given field interpreted differently. Thus, each instruction of an ISA is expressed using a given instruction format (and, if defined, in a given one of the instruction templates of that instruction format) and includes fields for specifying the operation and the operands. For example, an example ADD instruction has a specific opcode and an instruction format that includes an opcode field to specify that opcode and operand fields to select operands (source1/destination and source2); and an occurrence of this ADD instruction in an instruction stream will have specific contents in the operand fields that select specific operands. In addition, though the description below is made in the context of x86 ISA, it is within the knowledge of one skilled in the art to apply the teachings of the present disclosure in another ISA.

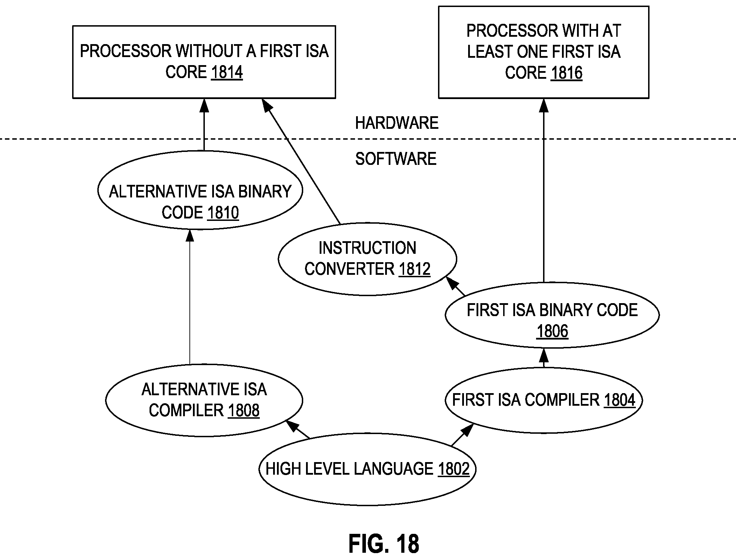

FIG. 18 is a block diagram illustrating the use of a software instruction converter to convert binary instructions in a source ISA to binary instructions in a target ISA according to examples. In the illustrated example, the instruction converter is a software instruction converter, although alternatively the instruction converter may be implemented in software, firmware, hardware, or various combinations thereof. FIG. 18 shows a program in a high-level language 1802 may be compiled using a first ISA compiler 1804 to generate first ISA binary code 1806 that may be natively executed by a processor with at least one first ISA core 1816. The processor with at least one first ISA core 1816 represents any processor that can perform substantially the same functions as an Intel^{®} processor with at least one first ISA core by compatibly executing or otherwise processing (1) a substantial portion of the first ISA or (2) object code versions of applications or other software targeted to run on an Intel processor with at least one first ISA core, in order to achieve substantially the same result as a processor with at least one first ISA core. The first ISA compiler 1804 represents a compiler that is operable to generate first ISA binary code 1806 (e.g., object code) that can, with or without additional linkage processing, be executed on the processor with at least one first ISA core 1816. Similarly, FIG. 18 shows the program in the high-level language 1802 may be compiled using an alternative ISA compiler 1808 to generate alternative ISA binary code 1810 that may be natively executed by a processor without a first ISA core 1814. The instruction converter 1812 is used to convert the first ISA binary code 1806 into code that may be natively executed by the processor without a first ISA core 1814. This converted code is not necessarily to be the same as the alternative ISA binary code 1810; however, the converted code will accomplish the general operation and be made up of instructions from the alternative ISA. Thus, the instruction converter 1812 represents software, firmware, hardware, or a combination thereof that, through emulation, simulation or any other process, allows a processor or other electronic device that does not have a first ISA processor or core to execute the first ISA binary code 1806.

### IP Core Implementations.

One or more aspects of at least some examples may be implemented by representative code stored on a machine-readable medium which represents and/or defines logic within an integrated circuit such as a processor. For example, the machine-readable medium may include instructions which represent various logic within the processor. When read by a machine, the instructions may cause the machine to fabricate the logic to perform the techniques described herein. Such representations, known as "IP cores," are reusable units of logic for an integrated circuit that may be stored on a tangible, machine-readable medium as a hardware model that describes the structure of the integrated circuit. The hardware model may be supplied to various customers or manufacturing facilities, which load the hardware model on fabrication machines that manufacture the integrated circuit. The integrated circuit may be fabricated such that the circuit performs operations described in association with any of the examples described herein.

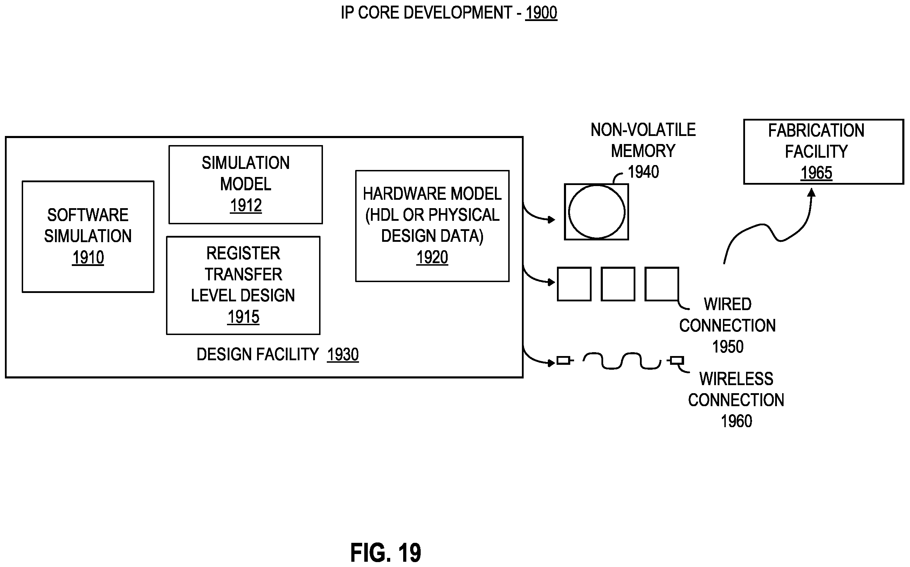

FIG. 19 is a block diagram illustrating an IP core development system 1900 that may be used to manufacture an integrated circuit to perform operations according to some examples. The IP core development system 1900 may be used to generate modular, re-usable designs that can be incorporated into a larger design or used to construct an entire integrated circuit (e.g., an SOC integrated circuit). A design facility 1930 can generate a software simulation 1910 of an IP core design in a high-level programming language (e.g., C/C++). The software simulation 1910 can be used to design, test, and verify the behavior of the IP core using a simulation model 1912. The simulation model 1912 may include functional, behavioral, and/or timing simulations. A register transfer level (RTL) design 1915 can then be created or synthesized from the simulation model 1912. The RTL design 1915 is an abstraction of the behavior of the integrated circuit that models the flow of digital signals between hardware registers, including the associated logic performed using the modeled digital signals. In addition to an RTL design 1915, lower-level designs at the logic level or transistor level may also be created, designed, or synthesized. Thus, the particular details of the initial design and simulation may vary.

The RTL design 1915 or equivalent may be further synthesized by the design facility into a hardware model 1920, which may be in a hardware description language (HDL), or some other representation of physical design data. The HDL may be further simulated or tested to verify the IP core design. The IP core design can be stored for delivery to a 3^{rd} party fabrication facility 1965 using non-volatile memory 1940 (e.g., hard disk, flash memory, or any non-volatile storage medium). Alternatively, the IP core design may be transmitted (e.g., via the Internet) over a wired connection 1950 or wireless connection 1960. The fabrication facility 1965 may then fabricate an integrated circuit that is based at least in part on the IP core design. The fabricated integrated circuit can be configured to perform operations in accordance with at least some examples described herein.

References to "some examples," "an example," etc., indicate that the example described may include a particular feature, structure, or characteristic, but every example may not necessarily include the particular feature, structure, or characteristic. Moreover, such phrases are not necessarily referring to the same example. Further, when a particular feature, structure, or characteristic is described in connection with an example, it is submitted that it is within the knowledge of one skilled in the art to affect such feature, structure, or characteristic in connection with other examples whether or not explicitly described.

Examples include, but are not limited to:
Example 1. An apparatus comprising: at least one built-in self-test controllerto perform a test on logic of the apparatus; storage to store test instructions associated with the test; a plurality of infield testing debug and status registers to store information about execution of the test instructions; and a plurality of infield control debug registers to control execution of the test instructions, wherein access to the plurality of infield testing debug registers and the plurality of infield control debug registers is programmable.
Example 2. The apparatus of example 1, wherein the built-in self-test controller is a memory built-in self-test controller.
Example 3. The apparatus of example 1, wherein the built-in self-test controller is a logic built-in self-test controller.
Example 4. The apparatus of any of examples 1-3, wherein access to the plurality of infield testing debug registers and the plurality of infield control debug registers is programmable to map both the plurality of infield testing debug registers and the plurality of infield control debug registers into a firmware accessible register space and a test access port (TAP) space.
Example 5. The apparatus of example 4, wherein an external debugger has access to both the firmware accessible register space and TAP space.
Example 6. The apparatus of any of examples 1-3, wherein access to the plurality of infield testing debug registers and the plurality of infield control debug registers is programmable to map the plurality of infield testing debug registers to a test access port (TAP) space and the plurality of infield control debug registers into a firmware accessible register space.
Example 7. The apparatus of example 6, wherein an external debugger has access to the firmware accessible register space.
Example 8. The apparatus of example 7, wherein infield firmware is capable of accessing the firmware accessible register space at a same time the external debugger is capable of accessing the TAP space.
Example 9. The apparatus of any of examples 1-8, further comprising:
   a chip-level test access port (TAP), wherein the chip-level TAP is to arbitrate access to the plurality of infield control debug registers between an external debugger and infield firmware.
Example 10. The apparatus of any of examples 1-9, wherein an external debugger is capable of controlling execution of the test.
Example 11. A system comprising: an apparatus comprising: at least one built-in self-test controller to perform a test on logic of the apparatus; storage to store test instructions associated with the test, a plurality of infield testing debug and status registers to store information about execution of the test instructions, and a plurality of infield control debug registers to control the test, wherein access to the plurality of infield testing debug registers and the plurality of infield control debug registers is programmable; and a debugger coupled to the apparatus to read at least one of the plurality of infield testing debug and status registers and plurality of infield control debug registers.
Example 12. The system of example 11, wherein the built-in self-test controller is a memory built-in self-test controller.
Example 13. The system of example 11, wherein the built-in self-test controller is a logic built-in self-test controller.
Example 14. The system of any of examples 11-13, wherein access to the plurality of infield testing debug registers and the plurality of infield control debug registers is programmable to map both the plurality of infield testing debug registers and the plurality of infield control debug registers into a firmware accessible register space and a test access port (TAP) space.
Example 15. The system of example 14, wherein an external debugger has access to both the firmware accessible register space and TAP space.
Example 16. The system of any of examples 11-13, wherein access to the plurality of infield testing debug registers and the plurality of infield control debug registers is programmable to map the plurality of infield testing debug registers to a test access port (TAP) space and the plurality of infield control debug registers into a firmware accessible register space.
Example 17. The system of example 16, wherein an external debugger has access to the firmware accessible register space.
Example 18. The system of example 17, wherein infield firmware is capable of accessing the firmware accessible register space at a same time the external debugger is capable of accessing the TAP space.
Example 19. The system of any of examples 11-18, further comprising:
   a chip-level test access port (TAP), wherein the chip-level TAP is to arbitrate access to the plurality of infield control debug registers between an external debugger and infield firmware.
Example 20. The system of any of examples 11-13, wherein an external debugger is capable of controlling execution of the test instructions.

Moreover, in the various examples described above, unless specifically noted otherwise, disjunctive language such as the phrase "at least one of A, B, or C" or "A, B, and/or C" is intended to be understood to mean either A, B, or C, or any combination thereof (i.e. A and B, A and C, B and C, and A, B and C).

The specification and drawings are, accordingly, to be regarded in an illustrative rather than a restrictive sense. It will, however, be evident that various modifications and changes may be made thereunto without departing from the broader spirit and scope of the disclosure as set forth in the claims.

## Claims

1. An apparatus comprising:
at least one built-in self-test controller to perform a test on logic of the apparatus;
storage to store test instructions associated with the test;
a plurality of infield testing debug and status registers to store information about execution of the test instructions; and
a plurality of infield control debug registers to control execution of the test instructions, wherein access to the plurality of infield testing debug registers and the plurality of infield control debug registers is programmable.

2. The apparatus of claim 1, wherein the built-in self-test controller is a memory built-in self-test controller.

3. The apparatus of claim 1, wherein the built-in self-test controller is a logic built-in self-test controller.

4. The apparatus of any of claims 1-3, wherein access to the plurality of infield testing debug registers and the plurality of infield control debug registers is programmable to map both the plurality of infield testing debug registers and the plurality of infield control debug registers into a firmware accessible register space and a test access port (TAP) space.

5. The apparatus of claim 4, wherein an external debugger has access to both the firmware accessible register space and TAP space.

6. The apparatus of any of claims 1-3, wherein access to the plurality of infield testing debug registers and the plurality of infield control debug registers is programmable to map the plurality of infield testing debug registers to a test access port (TAP) space and the plurality of infield control debug registers into a firmware accessible register space.

7. The apparatus of claim 6, wherein an external debugger has access to the firmware accessible register space.

8. The apparatus of claim 7, wherein infield firmware is capable of accessing the firmware accessible register space at a same time the external debugger is capable of accessing the TAP space.

9. The apparatus of any of claims 1-8, further comprising:
a chip-level test access port (TAP), wherein the chip-level TAP is to arbitrate access to the plurality of infield control debug registers between an external debugger and infield firmware.

10. The apparatus of any of claims 1-9, wherein an external debugger is capable of controlling execution of the test.

11. The apparatus of claim 10, further comprising:
a debugger coupled to the apparatus to read at least one of the plurality of infield testing debug and status registers and plurality of infield control debug registers.
